(19) Europäisches Patentamt / European Patent Office / Office européen des brevets

(11) **EP 4 501 877 A1**

(12) **EUROPEAN PATENT APPLICATION**
published in accordance with Art. 153(4) EPC

(43) Date of publication:
05.02.2025 Bulletin 2025/06

(21) Application number: 23774784.5

(22) Date of filing: 16.03.2023

(51) International Patent Classification (IPC):
*C03C 17/36* (2006.01)     *B32B 9/00* (2006.01)
*B32B 15/04* (2006.01)

(52) Cooperative Patent Classification (CPC):
B32B 9/00; B32B 15/04; C03C 17/36

(86) International application number:
PCT/JP2023/010478

(87) International publication number:
WO 2023/182188 (28.09.2023 Gazette 2023/39)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 25.03.2022 JP 2022049823

(71) Applicant: AGC INC.
Chiyoda-ku,
Tokyo 1008405 (JP)

(72) Inventor: YONETA Kiyoto
Tokyo 100-8405 (JP)

(74) Representative: Müller-Boré & Partner
Patentanwälte PartG mbB
Friedenheimer Brücke 21
80639 München (DE)

(54) **COATED SHEET GLASS, AND METHOD FOR PREPARING COATED SHEET GLASS**

(57) Patterns are less likely to appear on a surface of a plate glass including a low-emissive film and a protective film that protects the low-emissive film. The coated plate glass (Cg) includes: a plate glass (Gs) having a coated surface (Cs); a low-emissive film (Le) that is disposed on the coated surface (Cs) and includes a metallic layer and a dielectric layer; and a protective film (Pr) that is disposed on the low-emissive film (Le) and contains silicon oxide. The thickness of the protective film (Pr) varies at respective points. The deviation with respect to the minimum limit size (Ls) of the thickness at each point in the thickness at each point falls within the range of a tolerance (Tr) of the thickness at the corresponding point. The tolerance Tr is set to a value of 10% or less of the minimum limit size (Ls). When the coated plate glass (Cg) is observed on the protective film (Pr), the color difference ΔE between two points that are a point at which a thickness of the protective film Pr is a maximum limit size and a point at which a thickness of the protective film Pr is the minimum limit size Ls, is 3.5 or less.

Fig. 3

## Description

### Technical Field

The present invention relates to a coated plate glass including a low-emissive film including a metallic layer and a protective film that protects the low-emissive film.

### Background Art

Patent Literature 1 discloses a plate glass having a functional coating composed of zinc tin oxide (ZTO) and silver that are disposed one after another (paragraph [0070] of Patent Literature 1). A protective coating including aluminum oxide or silicon oxide is disposed on the functional coating (paragraph [0014] of Patent Literature 1).

Patent Literature 2 discloses a plate glass that includes a functional coating in which a silver layer is disposed between oxide layers of zinc or tin. Moreover, a topcoat composed of silica and zinc oxide covers the functional coating (Example 1 and Example 2 of Patent Literature 2).

Patent Literature 3 discloses a glass plate that includes an underlayer composed of tin oxide and a thin film composed of silica ($SiO_2$). On the surface of the thin film, two points having $\Delta E^*$ of two or less are present. The $\Delta E^*$ is determined based on a difference $\Delta L^*$ between $L^*$ values, a difference $\Delta a^*$ between $a^*$ values, and a difference $\Delta b^*$ between $b^*$ values in the $L^*a^*b^*$ color system (claim 10 of Patent Literature 3). Proper adjustment of $\Delta E^*$ improves the beautiful appearance of a thin film-including base material that includes a thin film-including silica as a main component (paragraph [0007] of Patent Literature 3). The glass plate may include a film in which a dielectric layer, a silver layer, and another dielectric layer are laminated in this order, on the surface opposite to the surface at the thin film side (paragraph [0039] of Patent Literature 3).

Example of Patent Literature 4 (paragraph [0072]) discloses that a perhydropolysilazane layer is coated on glass and this layer is heated to form a silica-based layer. In Example of Patent Literature 5, a coated film of a composition that includes tetraethoxysilane is formed on the surface of a heat ray reflective film. This coated film is heated and cured to prepare a silica film-including glass substrate.

### Citation List

### Patent Literature

[Patent Literature 1] Published Japanese Translation of PCT International Publication for Patent Application, No. 2004-522673
[Patent Literature 2] Published Japanese Translation of PCT International Publication for Patent Application, No. 2007-534603
[Patent Literature 3] International Patent Publication No. WO2019/189109
[Patent Literature 4] Published Japanese Translation of PCT International Publication for Patent Application, No. 2018-512369
[Patent Literature 5] International Patent Publication No. WO2022/014650

### Summary of Invention

### Technical Problem

When a plate glass is provided with a low-emissive film having a metallic layer, low emissivity (Low-E) against infrared rays can be obtained. Since the low-emissive film is easily peeled from the plate glass, the low-emissive film is protected with the silica-based protective film. The present inventors found that when the protective film is laminated on the low-emissive film, patterns such as stripe patterns easily appear on the surface of the plate glass. An object of the present invention is to provide a means for being less likely to form patterns on the surface of a plate glass including a low-emissive film and a protective film that protects the low-emissive film.

### Solution to Problem

<1> A coated plate glass including:

a plate glass having a coated surface,
a low-emissive film that is disposed on the coated surface and includes a metallic layer and a dielectric layer; and
a protective film that is disposed on the low-emissive film and based on silica,
in which a thickness at each point of the protective film has variation, a deviation with respect to a minimum limit size of the thickness at the each point in the thickness at the each point falls within a range of a tolerance of the thickness at the each point, and the tolerance is set to a value of 10% or less of the minimum limit size,
when the coated plate glass is observed from above the protective film, a color difference ΔE between two points that are a point at which a thickness of the protective film is a maximum limit size and a point at which a thickness of the protective film is the minimum limit size, is 3.5 or less, and
the color difference ΔE is determined by an equation described below:

[Expression 1]

$$\Delta E = \sqrt{(\Delta L^{\ast})^2 + (\Delta a^{\ast})^2 + (\Delta b^{\ast})^2}$$

in which $\Delta L^{\ast}$ is a difference between $L^{\ast}$ values at respective points in an $L^{\ast}a^{\ast}b^{\ast}$ color system,
$\Delta a^{\ast}$ is a difference between $a^{\ast}$ values at respective points in the $L^{\ast}a^{\ast}b^{\ast}$ color system, and
$\Delta b^{\ast}$ is a difference between $b^{\ast}$ values at respective points in the $L^{\ast}a^{\ast}b^{\ast}$ color system.

<2> The coated plate glass according to <1>,

in which the low-emissive film includes a plurality of dielectric layers, and
the plurality of dielectric layers includes: a first dielectric layer positioned between the coated surface of the plate glass and the metallic layer; and a second dielectric layer positioned between the metallic layer and the protective film.

<3> The coated plate glass according to <2>,

in which the low-emissive film further includes a plurality of buffer layers,
the plurality of buffer layers includes: a first buffer layer positioned between the first dielectric layer and the metallic layer; and a second buffer layer positioned between the metallic layer and the second dielectric layer,
the first buffer layer includes a composition having a refractive index higher than a refractive index of the first dielectric layer and a refractive index of the metallic layer, and is thinner than the first dielectric layer, and
a refractive index of the second buffer layer includes a composition having a refractive index higher than the refractive index of the metallic layer and a refractive index of the second dielectric layer, and is thinner than the second dielectric layer.

<4> The coated plate glass according to <2>,

in which the low-emissive film includes, in addition to the metallic layer that is referred to as a first metallic layer later, a second metallic layer positioned between the second dielectric layer and the protective film,
the plurality of dielectric layers further includes a third dielectric layer positioned between the second metallic layer and the protective film,
the dielectric layer and the metallic layer adjacent to each other are connected by the buffer layer, and
each buffer layer includes a composition having a refractive index higher than refractive indexes of the dielectric layer and the metallic layer connected by the buffer layer, and is thinner than each dielectric layer.

<5> The coated glass according to <1>,
in which a minimum value of the thickness of the protective film actually measured on the coated surface is 25 nm or more and 200 nm or less.
<6> The coated glass according to <5>,
in which the minimum value of the thickness of the protective film actually measured on the coated surface is 75 nm or less.
<7> The coated glass according to <5>,
in which the minimum value of the thickness of the protective film on the coated surface is 50 nm or more.
<8> The coated plate glass according to<5>,

in which the low-emissive film includes, from the protective film toward the plate glass, nine layers described below:

· third dielectric layer: 10 to 70 nm
· buffer layer: 1 to 20 nm
· second metallic layer: 1 to 30 nm
· buffer layer: 1 to 20 nm
· second dielectric layer: 10 to 120 nm
· buffer layer: 1 to 20 nm
· first metallic layer: 1 to 30 nm
· buffer layer: 1 to 20 nm
· first dielectric layer: 10 to 70 nm.

<9> The coated plate glass according to <5>,
in which the low-emissive film includes, from the protective film toward the plate glass, nine layers described below:

· third dielectric layer: 10 to 45 nm
· buffer layer: 1 to 9 nm
· second metallic layer: 5 to 20 nm
· buffer layer: 1 to 9 nm
· second dielectric layer: 51 to 99 nm
· buffer layer: 1 to 9 nm
· first metallic layer: 8 to 20 nm
· buffer layer: 1 to 9 nm
· first dielectric layer: 16 to 48 nm.

<10> The coated plate glass according to <5>,
in which the low-emissive film includes, from the protective film toward the plate glass, nine layers described below:

· third dielectric layer: 10 to 45 nm
· buffer layer: 1 to 9 nm
· second metallic layer: 12 to 20 nm
· buffer layer: 1 to 9 nm
· second dielectric layer: 51 to 99 nm
· buffer layer: 5 to 9 nm
· first metallic layer: 8 to 12 nm
· buffer layer: 1 to 9 nm
· first dielectric layer: 16 to 48 nm.

<11> The coated plate glass according to <5>,
in which the low-emissive film includes, from the protective film toward the plate glass, nine layers described below:

· third dielectric layer: 10 to 45 nm
· buffer layer: 1 to 9 nm
· second metallic layer: 5 to 18 nm
· buffer layer: 1 to 9 nm
· second dielectric layer: 51 to 99 nm
· buffer layer: 1 to 9 nm
· first metallic layer: 12 to 20 nm
· buffer layer: 1 to 9 nm
· first dielectric layer: 16 to 48 nm.

<12> The coated plate glass according to <5>,
in which when the plate glass is observed from a side of the protective film, the coated surface has an a* value of -15 or more and 0 or less and a b* value of - 20 or more and 0 or less.
<13> The coated plate glass according to <5>,
in which when the plate glass is observed from a side of the protective film, the coated surface has an a* value of -10 or more and 0 or less and a b* value of - 20 or more and 0 or less.
<14> The coated plate glass according to <1>,

in which the coated plate glass is a single plate glass.

<15> The coated plate glass according to <14>,

in which when a reflectance of the plate glass is measured at a wavelength of from 380 nm to 780 nm from a side of the low-emissive film, the reflectance is 15% or less.

<16> The coated plate glass according to <14>,

in which when a reflectance of the plate glass is measured at a wavelength of from 380 nm to 780 nm from a side of the low-emissive film, the reflectance is 5% or less.

<17> A coated plate glass including:

a plate glass having a coated surface;

a low-emissive film that is disposed on the coated surface and includes a metallic layer and a dielectric layer; and

a protective film that is disposed on the low-emissive film and based on silica,

in which when a thickness at each point of the protective film is measured, a difference between a maximum thickness of the protective film and a minimum thickness of the protective film is a value of 10% or less of the minimum thickness, and

when the coated plate glass is observed from above the protective film, a color difference $\Delta E$ between two points that are a point of the maximum thickness and a point of the minimum thickness, is 3.5 or less, and

the color difference $\Delta E$ is determined by an equation described below:

[Expression 2]

$$\Delta E = \sqrt{(\Delta L^*)^2 + (\Delta a^*)^2 + (\Delta b^*)^2}$$

in which $\Delta L^*$ is a difference between $L^*$ values at respective points in an $L^*a^*b^*$ color system,

$\Delta a^*$ is a difference between $a^*$ values at respective points in the $L^*a^*b^*$ color system, and

$\Delta b^*$ is a difference between $b^*$ values at respective points in the $L^*a^*b^*$ color system.

<18> A method for preparing the coated plate glass according to any one of <1> to <17>, the method including:

laminating sol of alkoxysilane on the low-emissive film through roll coating, die coating, or spray coating to gelate the sol on the low-emissive film, in which the protective film is a silica film;

or

laminating silazane on the low-emissive film through roll coating, die coating, or spray coating to convert the silazane into silica on the low-emissive film, in which the protective film is a silica film.

<19> A method for designing the coated plate glass according to any one of <1> to <17> by selecting, from a plurality of patterns obtained by simulations, a combination of a thickness of the protective film, a thickness of each layer in the low-emissive film, and a thickness of the plate glass, the method including:

determining a spectral solid angle reflectance R ($\lambda$) on the coated surface in each pattern of a combination of the minimum limit size of the thickness of the protective film, the thickness of each layer in the low-emissive film, and the thickness of the plate glass, and replacing the thickness of the protective film with the maximum limit size in each pattern, to determine the spectral solid angle reflectance R ($\lambda$),

obtaining a set of an $L^*$ value, an $a^*$ value, and a $b^*$ value in an $L^*a^*b^*$ color system in each pattern, based on the spectral solid angle reflectance R ($\lambda$) according to the minimum limit size and the maximum limit size of the thickness of the protective film; and

determining a color difference $\Delta E$ represented by an equation described below in each pattern, based on the equation below:

[Expression 3]

$$\Delta E = \sqrt{(\Delta L^*)^2 + (\Delta a^*)^2 + (\Delta b^*)^2}$$

$\Delta L^*$ is a difference between an $L^*$ value corresponding to the minimum limit size of the thickness of the protective film and an $L^*$ value corresponding to the maximum limit size of the thickness of the protective film,

$\Delta a^*$ is a difference between an $a^*$ value corresponding to the minimum limit size of the thickness of the protective film and an $a^*$ value corresponding to the maximum limit size of the thickness of the protective film, and

$\Delta b^*$ is a difference between a $b^*$ value corresponding to the minimum limit size of the thickness of the protective film and a b* value corresponding to the maximum limit size of the thickness of the protective film.

**Advantageous Effects of Invention**

The present invention makes it possible to provide a means for being less likely to form patterns on the surface of a plate glass including a low-emissive film including a metallic layer and a protective film that protects the low-emissive film.

**Brief Description of Drawings**

[Fig. 1] Cross-sectional view of a coated plate glass;
[Fig. 2] Cross-sectional view of a laminate;
[Fig. 3] Cross-sectional view of a protective film;
[Fig. 4] Graph of spectral solid angle reflectance R (λ);
[Fig. 5] Graph of spectral distribution S (λ) of standard illuminant;
[Fig. 6] Graph of color-matching functions x⁻ (λ), y⁻ (λ), and z⁻ (λ);
[Fig. 7] Drawing of the plane of incidence of white light;
[Fig. 8] Exploded view of a low-emissive film;
[Fig. 9] Plots of a* values and b* values in a coordinate system;
[Fig. 10] Photograph of a protective film subjected to roll coating;
[Fig. 11] Graph showing a change in color differences ΔE with respect to deviations of thicknesses of a protective film;
[Fig. 12] Plots of a pattern including a low-emissive film composed of nine layers;
[Fig. 13] Plots of 13 patterns where the color difference ΔE<1 is satisfied;
[Fig. 14] Plots of 482 patterns where the color difference ΔE<2 is satisfied;
[Fig. 15] Plots of 1,949 patterns where the color difference ΔE<3.5 is satisfied;
[Fig. 16] Plots of 24 patterns that satisfy the hue designation;
[Fig. 17] Plots of 206 patterns that satisfy the hue designation;
[Fig. 18] Classification of 1,713 patterns based on the hue designation and color differences ΔE;
[Fig. 19] Plots of patterns including a low-emissive film composed of three layers;
[Fig. 20] Plots of 390 patterns where the color difference ΔE<1 is satisfied;
[Fig. 21] Plots of 1,136 patterns where the color difference ΔE<2 is satisfied;
[Fig. 22] Plots of 1,753 patterns where the color difference ΔE<3 is satisfied;
[Fig. 23] Plots of patterns including a low-emissive film composed of five layers;
[Fig. 24] Plots of 13 patterns where the color difference ΔE<1 is satisfied;
[Fig. 25] Plots of 519 patterns where the color difference ΔE<2 is satisfied;
[Fig. 26] Plots of 1,556 patterns where the color difference ΔE<3 is satisfied;
[Fig. 27] Plots of patterns including a low-emissive film composed of seven layers;
[Fig. 28] Plots of 95 patterns where the color difference ΔE<1 is satisfied;
[Fig. 29] Plots of 408 patterns where the color difference ΔE<2 is satisfied;
[Fig. 30] Plots of 1,088 patterns where the color difference ΔE<3 is satisfied;
[Fig. 31] Plots of patterns including a low-emissive film composed of seven layers;
[Fig. 32] Plots of 1,588 patterns where the color difference ΔE<3.5 is satisfied; and
[Fig. 33] Plots of 171 patterns that satisfy the hue designation.

**Description of Embodiments**

<Color of surface of coated plate glass>

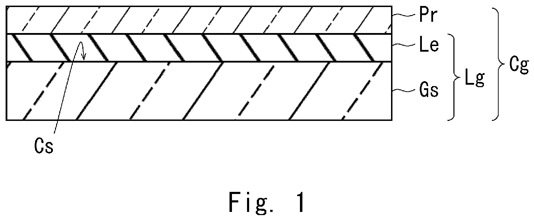

Fig. 1 represents a cross section of a coated plate glass Cg. The coated plate glass Cg includes a plate glass Gs. The plate glass Gs includes a coated surface Cs. In one embodiment, the plate glass Gs is a single plate glass or a laminated glass. The coated plate glass Cg includes a low-emissive film Le. A laminate Lg is obtained by laminating the low-emissive film Le on the plate glass Gs. The coated plate glass Cg includes a protective film Pr in addition to the laminate Lg.

The plate glass Gs may be appropriately selected depending on, for example, the application of the coated plate glass Cg. Examples of materials of the plate glass Gs include heat absorbing glass, clear glass, soda lime glass, quartz glass, borosilicate glass, alkali-free glass, green glass, UV green glass, and lithium aluminum silicate glass. One example of the thickness of the plate glass Gs is from 0.2 to 6.0 mm. The plate glass Gs may be flat or curved. As one example of the complex refractive index of light having a wavelength of 590 nm of the plate glass Gs, the refractive index (real part) is from 1.40 to 2.00, and the extinction coefficient (imaginary part) is from $2.5 \times 10^{-7}$ to $10.0 \times 10^{-7}$.

In one embodiment, when a reflectance of the coated plate glass Cg at a wavelength of from 380 nm to 780 nm is measured from a side of the protective film Pr, the reflectance is from 0% to 15%, preferably from 0% to 10%, and more preferably from 0% to 5%. In that embodiment, the reflectance is 5, 2, or 1%. The coated plate glass Cg having such a reflectance can be suitably used for window glass of buildings, roofs, windshields, or windows of automobiles. The roof can be called a sunroof or a moonroof. The windshield may be continuously connected to the sunroof.

The protective film Pr shown in Fig. 1 is provided on the low-emissive film Le. When the coated plate glass Cg does not include the protective film Pr, the low-emissive film Le is easily peeled from the laminate Lg. This can be protected by protecting the low-emissive film Le by the protective film Pr. The protective film Pr is a silica-based coating film, particularly a silica film.

In one embodiment shown in Fig. 1, sol of alkoxysilane is laminated on the low-emissive film Le through roll coating, die coating, or spray coating. The layer of the sol is heated to obtain a film of the sol; i.e., a silica film. The silica film is considered as the protective film Pr.

In another embodiment shown in Fig. 1, silazane, for example, perhydropolysilazane is laminated on the low-emissive film Le through roll coating, die coating, or spray coating. The layer of silazane is heated to convert it into a silica film. The silica film is considered as the protective film Pr.

The protective film Pr shown in Fig. 1 may include a component other than silicon oxide. Examples of the component include ceramic particles, a curing agent, and a residual solvent. The ceramic particles and the curing agent are useful for curing the protective film Pr. Examples of the ceramic particles include zirconia particles. In another embodiment, the silica-based film may be obtained by dispersing silica particles in the silica film. In one embodiment of the composition of the protective film Pr, the component with the largest content weight is silicon oxide, particularly an oxide of silicon dioxide.

One example of the thickness of the protective film Pr is from 25 to 200 nm. As one example of the complex refractive index of light having a wavelength of 590 nm of the protective film Pr, the refractive index is from 1.40 to 1.80, and the extinction coefficient is from 0.0 to $4.4 \times 10^{-2}$.

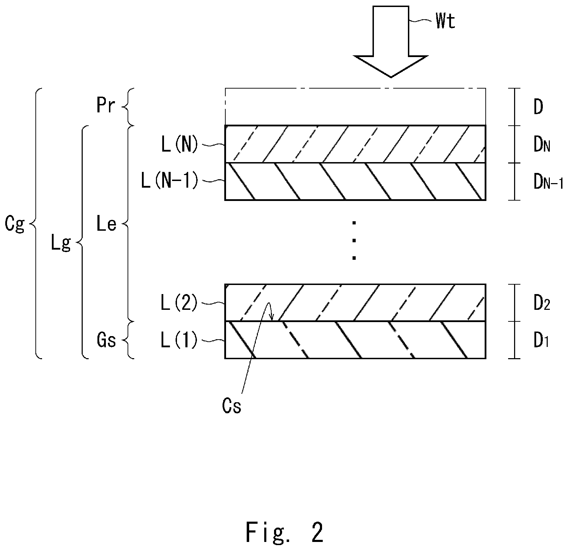

Fig. 2 represents a cross section of a laminate Lg. The laminate Lg is formed by laminating a total of N layers from Layer L (1) to Layer L (N) in order starting from a side of the plate glass Gs and ending at a side of the protective film Pr. The Layer L (1) is the plate glass Gs. The low-emissive film Le is composed of Layer L (2) $\cdots$ Layer L (N-1), and the Layer L (N). The Layer L (1), the Layer L (2) $\cdots$ the Layer L (N-1), and the Layer L (N) may be referred to as the first layer, the second layer, $\cdots$ the N-1$^{th}$ layer, and the N$^{th}$ layer.

In one embodiment shown in Fig. 2, any of layers positioned between the Layer L (2) and the Layer L (N) is a metallic layer. In one embodiment, the metallic layer is a layer composed of a non-oxide metal. In one embodiment, the metallic layer is a layer of a conductive metal.

Examples of materials of the conductive metal include a metal simple substance selected from Ag, Cu, Au, and Al or an alloy thereof, and those obtained by doping the metal simple substance or the alloy with a transition metal such as Mn, Fe, Co, or Ni. Preferable examples thereof include a metal selected from Ag and Cu or an alloy thereof, or those obtained by doping the metal simple substance or the alloy thereof with the transition metal such as Mn, Fe, Co, or Ni.

One example of the thickness of the metallic layer is from 1 to 30 nm, and preferably from 5 to 20 nm. As one example of the complex refractive index of light having a wavelength of 590 nm of the metallic layer, the refractive index is from 0.10 to 1.20, and the extinction coefficient is from 2.00 to 8.00.

The low-emissive film Le includes a dielectric layer other than the metallic layer. In one embodiment, the Layer L (2) and the Layer L (N) are a dielectric layer.

Examples of materials of the dielectric include oxides, nitrides, oxynitride of one or more kinds of metals selected from Si, Sn, Zn, Al, Ti, Zr, Nb, Ta, Ni, and Cr, and those obtained by doping these metal simple substances with another metal. Preferable examples thereof include oxides, nitrides, and oxynitride of one or more kinds of metals selected from Si, Sn, Zn, Ti, Zr, and Ni. The dielectric layer is formed of, for example, silicon nitride (SiN).

One example of the thickness of the dielectric layer is 10 to 120 nm, and preferably from 15 to 100 nm. As one example of the complex refractive index of light having a wavelength of 590 nm of the dielectric layer, the refractive index is from 1.8 to 2.2, and the extinction coefficient is from 0.00 to 0.01. The dielectric layer preferably has a larger refractive index than the metallic layer.

The Layer L (1), Layer L (2)$\cdots$Layer L (N-1), and the Layer L (N) shown in Fig. 2 have thickness $D_1$, thickness $D_2\cdots$thickness $D_{N-1}$, and thickness $D_N$, respectively. The plate glass Gs has thickness $D_1$. The low-emissive film Le has a total of thicknesses of the thickness $D_2 \cdots$ the thickness $D_{N-1}$, and the thickness $D_N$. In one embodiment, the thickness $D_1$ of the plate glass Gs is larger than the thickness of the low-emissive film Le. The protective film Pr has a thickness D. In one embodiment, the thickness $D_1$ of the plate glass Gs is larger than the thickness D of the protective film Pr. The way of using these thickness values will be described later.

The white light Wt shown in Fig. 2 comes in the laminate Lg from a side of the protective film Pr. While the white light Wt is transmitted through each layer in the laminate Lg, the white light Wt is reflected in each layer, and then, the white light Wt is transmitted in each layer again, and comes out from a side of the protective film Pr.

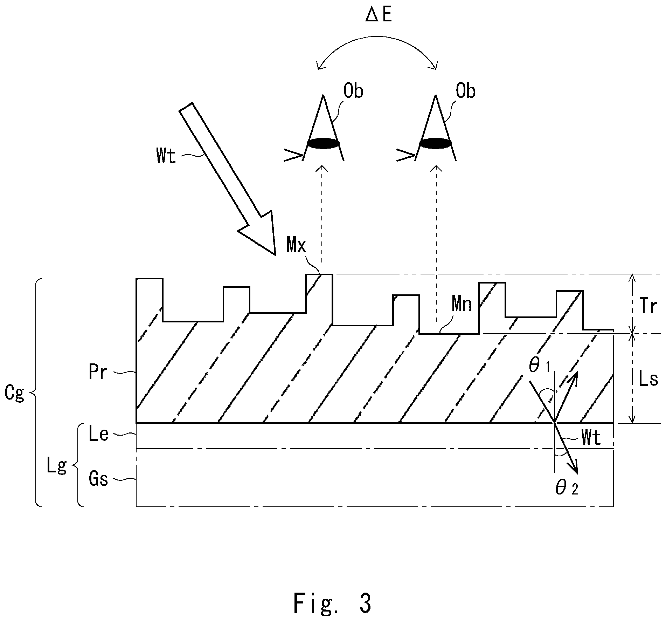

Fig. 3 shows a cross section of the protective film Pr. The surface of the protective film Pr has unevenness. The thickness of each point on the protective film Pr has variation. The variation shown in the figure is emphasized. When an observer Ob observes the coated plate glass Cg from above the protective film Pr, there is the point Mx as the maximum limit size, which is the maximum thickness of the protective film Pr in terms of design. The maximum value of the thickness having variation on the coated surface Cs in terms of design is considered as the maximum limit size. In terms of design, there is also the point Mn as the minimum limit size, which is the minimum thickness of the protective film Pr. The minimum value of the thickness having variation on the coated surface Cs in terms of design is considered as the minimum limit size Ls.

As shown in Fig. 3, the minimum limit size Ls of the thicknesses of the protective film Pr is considered as a standard value. The thickness at each point on the protective film Pr has a deviation with respect to the standard value. The deviation falls within the range of the tolerance Tr of the thickness of the protective film Pr. The tolerance Tr is a difference between the maximum limit size and the minimum limit size Ls of the thickness of the protective film Pr. The deviation in the thickness of each point of the protective film Pr is a positive value.

The thickness D at each point of the protective film Pr shown in Fig. 2 and other figures is larger than the minimum limit size Ls shown in Fig. 3, and falls within a range smaller than the maximum limit size. The thickness D at each point of the protective film Pr can be identified by exploring the cross section of the protective film Pr by, for example, a combination of SEM (scanning electron microscope) and EDX (energy dispersive X-ray spectroscopy). In addition, measurement can be performed by an ellipsometer.

In one embodiment shown in Fig. 3, the tolerance Tr has a value of from 0% to 10% of the minimum limit size Ls of the thickness of the protective film Pr. In one embodiment, the tolerance Tr is 5%, 2%, 1% of the minimum limit size Ls. Here, the tolerance Tr is larger than 0. The tolerance Tr may be any value of 5%, 2%, and 1% of the minimum limit size Ls of the thickness at each point on the protective film Pr. In one embodiment, the minimum limit size Ls of the thickness of the protective film Pr is smaller than the thickness of the entire low-emissive film Le. In one embodiment, the minimum limit size Ls of the thickness of the protective film Pr is smaller than the thickness of the plate glass.

As shown in Fig. 3, the observer Ob receives the white light Wt reflected at the coated plate glass Cg. The interference of light occurs depending on a change in the thickness of the protective film Pr within a range of the tolerance Tr. The interference of light slightly colors the coated plate glass Cg. The magnitude of a change in hue can be measured by the color difference $\Delta E$. The color difference $\Delta E$ observed by the observer Ob is determined by the following equation (I). [Expression 4]

$$\Delta E = \sqrt{(\Delta L^*)^2 + (\Delta a^*)^2 + (\Delta b^*)^2} \qquad (\text{I})$$

$\Delta L^*$ is a difference between the L* value at the point Mx and the L* value at the point Mn on the protective film Pr in the L*a*b* color system.
$\Delta a^*$ is a difference between the a* value at the point Mx and the a* value at the point Mn on the protective film Pr in the L*a*b* color system.
$\Delta b^*$ is a difference between the b* value at the point Mx and the b* value at the point Mn on the protective film Pr in the L*a*b* color system.

A slight change in hue observed on the protective film Pr as shown in Fig. 3 falls within a predetermined range. In the present embodiment, the color difference $\Delta E$ between the hue at the point Mx and the hue at the point Mn is 3.5 or less. Here, the color difference $\Delta E$ is larger than 0. Here, unless otherwise specified, the color difference $\Delta E$ refers to a color difference between the hue at the point Mx and the hue at the point Mn. Preferably, the color difference $\Delta E$ is 3 or less, 2.5 or less, 2 or less, 1.5 or less, 1 or less, or 0.5 or less.

<Determination of color difference $\Delta E$ based on tolerance of thickness of protective film>

In order to determine a color difference $\Delta E$ from a difference in thickness of the protective film Pr at the point Mx and the point Mn shown in Fig. 3, the following calculation is performed. Note that, the point Mx and the point Mn do not always produce the largest color difference $\Delta E$. For example, when the thickness of the protective film Pr is an intermediate value, this may possibly result in hue that is largely different from hue at another point. This condition will be described later, and first, a method for determining the color difference $\Delta E$ between the hue at the point Mx and the hue at the point Mn will be described.

First, from the thickness of the protective film Pr shown in Fig. 3, the complex refractive index $m_p$ ($\lambda$) of the protective film, and the complex amplitude reflectance $r_{LowE}$ ($\lambda$) on the surface of the laminate Lg, the complex amplitude reflectance r ($\lambda$) of the coated plate glass Cg is determined. The complex amplitude reflectance r ($\lambda$) is a function of the wavelength $\lambda$ of light in the white light Wt that is reflected in the coated plate glass Cg.

[Expression 5]

$$r(\lambda) = \frac{\dfrac{n_{air} \cos\theta_1 - m_p(\lambda) \cos\theta_2(\lambda)}{n_{air} \cos\theta_1 + m_p} + r_{LowE}(\lambda) \times e^{i\frac{4\pi m_p(\lambda)\cos\theta_2(\lambda)}{\lambda}D}}{1 + r_{LowE}(\lambda) \times \dfrac{n_{air} \, co(\lambda)\cos\theta_2(\lambda)\, s\,\theta_1 - m_p(\lambda)\cos\theta_2(\lambda)}{n_{air} \cos\theta_1 + m_p(\lambda)\cos\theta_2(\lambda)} \times e^{i\frac{4\pi m_p(\lambda)\cos\theta_2(\lambda)}{\lambda}D}}$$

[Expression 6]

$$\cos\theta_2(\lambda) = \sqrt{1 - \left(\frac{n_p}{n_{air}(\lambda)}\sin\theta_1\right)^2}$$

$n_{air}$: Refractive index of air
$m_p$ ($\lambda$): Complex refractive index of protective film Pr shown in Fig. 3

$$m_p\ (\lambda) = n_p\ (\lambda) + ik_p\ (\lambda)$$

$n_p$ ($\lambda$): Function of refractive index of protective film Pr with respect to light having wavelength $\lambda$. Note that, the refractive index is a physical property value, and may be assumed to be constant regardless of the wavelength $\lambda$.
$k_p$ ($\lambda$): Function of extinction coefficient of protective film Pr with respect to light having wavelength $\lambda$. Note that, the extinction coefficient is a physical property value, and may be assumed to be constant regardless of the wavelength $\lambda$.
i: Imaginary unit
$\theta_1$: Incidence angle of light at boundary between low-emissive film Le and protective film Pr
$\theta_2$ ($\lambda$): Function of angle of refraction of light having wavelength $\lambda$ at boundary between low-emissive film Le and protective film Pr
$r_{LowE}$ ($\lambda$): Function of complex amplitude reflectance of surface of laminate Lg
$\lambda$: Wavelength of light in white light Wt
D: Thickness of protective film Pr

Here, in order to simplify the calculation, the refractive index of air is approximated as $n_{air}$ = 1 regardless of the wavelength $\lambda$ of light. Moreover, in order to simplify the calculation, the incidence angle $\theta_1$ of light and the angle of refraction $\theta_2$ ($\lambda$) are set to 0. At this time, the complex amplitude reflectance r ($\lambda$) is determined from the $r_{LowE}$ ($\lambda$) and the thickness D of the protective film Pr by the following equation.

[Expression 7]

$$r(\lambda) = \frac{\dfrac{1 - n_p(\lambda)}{1 + n_p(\lambda)} + r_{LowE}(\lambda) \times e^{i\frac{4\pi n_p(\lambda)}{\lambda}D}}{1 + r_{LowE}(\lambda) \times \dfrac{1 - n_p(\lambda)}{1 + n_p(\lambda)} \times e^{i\frac{4\pi n_p(\lambda)}{\lambda}D}}$$

When the protective film Pr shown in Fig. 3 is based on silica ($SiO_2$), it may be assumed that the refractive index $n_p$ ($\lambda$) of the protective film Pr has a constant value of 1.457 regardless of the wavelength. Furthermore, it may be assumed that the extinction coefficient $k_p$ ($\lambda$) of the protective film Pr has a constant value of 0.00 regardless of the wavelength.
From the complex amplitude reflectance r ($\lambda$) shown in Fig. 3, the spectral solid angle reflectance R ($\lambda$) is determined by the following equation. The spectral solid angle reflectance R ($\lambda$) is a function of the wavelength $\lambda$ of light in the white light Wt reflected in the coated plate glass Cg.

[Expression 8]

$$R(\lambda) = |r(\lambda)|^2$$

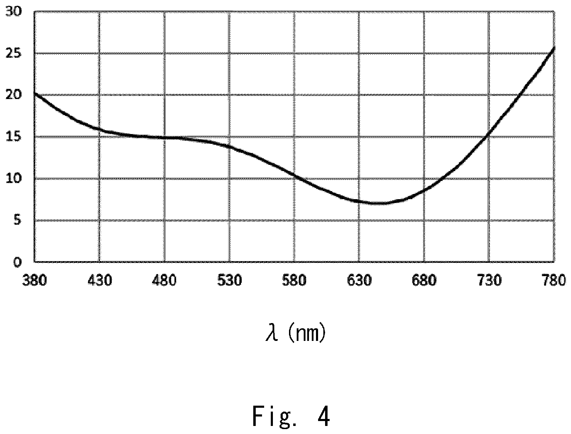

Fig. 4 is an example of a curved line showing values of the spectral solid angle reflectance R ($\lambda$) when the wavelength $\lambda$ changes from 380 nm to 780 nm.

Next, from the spectral solid angle reflectance R ($\lambda$) and the spectral distribution S ($\lambda$) of the standard illuminant used for color display, the set of tristimulus values X, Y, and Z of the object color by reflection is determined by the following equation. In the following equation, the wavelength of from 380 nm to 780 nm of visible rays is used. The upper limit of the wavelength may be any value within the range of from 730 nm to 780 nm, not 780 nm.

[Expression 9]

$$X = \frac{100}{\int_{380}^{780} S(\lambda)\bar{y}(\lambda)d\lambda} \times \int_{380}^{780} S(\lambda)R(\lambda)\bar{x}(\lambda)d\lambda$$

[Expression 10]

$$Y = \frac{100}{\int_{380}^{780} S(\lambda)\bar{y}(\lambda)d\lambda} \times \int_{380}^{780} S(\lambda)R(\lambda)\bar{y}(\lambda)d\lambda$$

[Expression 11]

$$Z = \frac{100}{\int_{380}^{780} S(\lambda)\bar{y}(\lambda)d\lambda} \times \int_{380}^{780} S(\lambda)R(\lambda)\bar{z}(\lambda)d\lambda$$

S ($\lambda$): Spectral distribution of standard illuminant used for color display
x⁻ ($\lambda$): Color-matching function
y⁻ ($\lambda$): Color-matching function
z⁻ ($\lambda$): Color-matching function

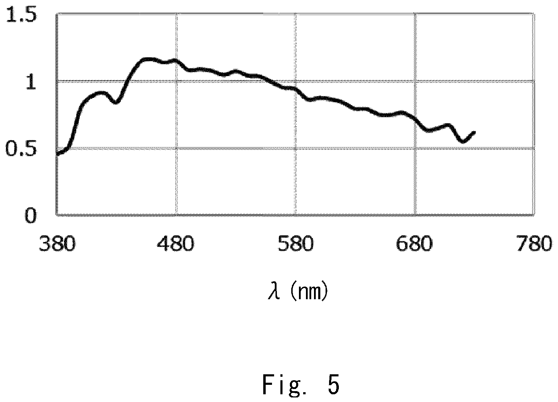

Fig. 5 is an example of a curved line showing values of the spectral distribution S ($\lambda$) of the standard illuminant when the wavelength $\lambda$ changes from 380 nm to 730 nm. The spectral distribution S ($\lambda$) of the standard illuminant may be the spectral distribution of the standard light source D65 of CIE (International Commission on Illumination). When the ISO 10526:1999/CIE S005/E-1998 is cited, it describes that "[D65] is intended to represent average daylight, and its correlated color temperature is approximately 6500 K. The CIE standard light source D65 can be used for all daylight colorimetry calculations unless otherwise specified for the light source. It is known that the relative spectral distribution of daylight varies depending on season, time, and geographical location, particularly in the ultraviolet region." The spectral distribution S ($\lambda$) is also described in JIS Z8720.

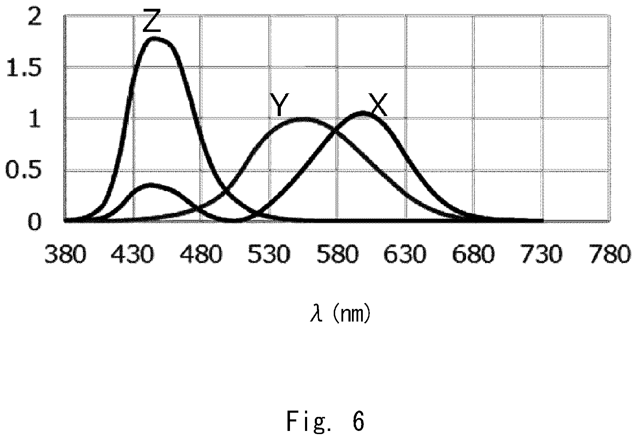

Fig. 6 is an example of a curved line showing values of the color-matching functions x⁻ ($\lambda$), y⁻ ($\lambda$), and z⁻ ($\lambda$) when the wavelength $\lambda$ changes from 380 nm to 730 nm.

The tristimulus values X, Y, and Z may be determined by the following approximate equations.

[Expression 12]

$$X = \frac{100}{\sum_{380}^{780} S(\lambda)\bar{y}(\lambda)d\lambda} \times \sum_{380}^{780} S(\lambda)R(\lambda)\bar{x}(\lambda)d\lambda$$

[Expression 13]

$$Y = \frac{100}{\sum_{380}^{780} S(\lambda)\bar{y}(\lambda)d\lambda} \times \sum_{380}^{780} S(\lambda)R(\lambda)\bar{y}(\lambda)d\lambda$$

[Expression 14]

$$Z = \frac{100}{\sum_{380}^{780} S(\lambda)\bar{y}(\lambda)d\lambda} \times \sum_{380}^{780} S(\lambda)R(\lambda)\bar{z}(\lambda)d\lambda$$

For example, when the interval of the wavelength is $d\lambda$ = 10 nm, the spectral distribution S ($\lambda$) of the standard illuminant and the color-matching functions x⁻ ($\lambda$), y⁻ ($\lambda$), and z⁻ ($\lambda$) as described below may be used.

[Table 1]

| $\lambda$ (nm) | $S(\lambda)$ | x⁻ ($\lambda$) | y⁻ ($\lambda$) | z⁻ ($\lambda$) | $\lambda$ (nm) | $S(\lambda)$ | x⁻ ($\lambda$) | y⁻ ($\lambda$) | z⁻ ($\lambda$) |
|---|---|---|---|---|---|---|---|---|---|
| 380 | 50.00 | 0.0014 | 0.0000 | 0.0065 | 560 | 90.00 | 0.5945 | 0.9950 | 0.0039 |
| 390 | 50.00 | 0.0042 | 0.0001 | 0.0201 | 570 | 86.01 | 0.7621 | 0.9520 | 0.0021 |
| 400 | 71.45 | 0.0143 | 0.0004 | 0.0679 | 580 | 84.97 | 0.9163 | 0.8700 | 0.0017 |
| 410 | 80.20 | 0.0435 | 0.0012 | 0.2074 | 590 | 79.19 | 1.0263 | 0.7570 | 0.0011 |
| 420 | 81.75 | 0.1344 | 0.0040 | 0.6456 | 600 | 98.27 | 1.0622 | 0.6310 | 0.0008 |
| 430 | 75.08 | 0.2839 | 0.0116 | 1.3856 | 610 | 97.41 | 1.0026 | 0.5030 | 0.0003 |
| 440 | 92.94 | 0.3483 | 0.0230 | 1.7471 | 620 | 94.90 | 0.8544 | 0.3810 | 0.0002 |
| 450 | 105.49 | 0.3362 | 0.0380 | 1.7721 | 630 | 90.13 | 0.6424 | 0.2650 | 0.0000 |
| 460 | 110.31 | 0.2908 | 0.0600 | 1.6692 | 640 | 89.97 | 0.4479 | 0.1750 | 0.0000 |
| 470 | 120.00 | 0.1954 | 0.0910 | 1.2876 | 650 | 85.97 | 0.2835 | 0.1070 | 0.0000 |
| 480 | 120.00 | 0.0956 | 0.1390 | 0.8130 | 660 | 85.69 | 0.1649 | 0.0610 | 0.0000 |
| 490 | 119.12 | 0.0320 | 0.2080 | 0.4652 | 670 | 87.15 | 0.0874 | 0.0320 | 0.0000 |
| 500 | 119.82 | 0.0049 | 0.3230 | 0.2720 | 680 | 82.77 | 0.0468 | 0.0170 | 0.0000 |
| 510 | 118.41 | 0.0093 | 0.5030 | 0.1582 | 690 | 74.42 | 0.0227 | 0.0082 | 0.0000 |
| 520 | 115.42 | 0.0633 | 0.7100 | 0.0782 | 700 | 75.62 | 0.0114 | 0.0041 | 0.0000 |
| 530 | 98.25 | 0.1655 | 0.8620 | 0.0422 | 710 | 77.57 | 0.0058 | 0.0021 | 0.0000 |
| 540 | 94.83 | 0.2904 | 0.9540 | 0.0203 | 720 | 65.50 | 0.0029 | 0.0010 | 0.0000 |
| 550 | 94.29 | 0.4334 | 0.9950 | 0.0087 | 730 | 70.59 | 0.0014 | 0.0005 | 0.0000 |

The set of the tristimulus values X, Y, and Z is determined by each of the minimum value (= Ls) and the maximum value (= Ls + Tr) of the thickness D of the protective film Pr shown in Fig. 3. From the set of the tristimulus values X, Y, and Z of the object color, the set of the L* value, the a* value, and the b* value in the L*a*b* color system, which corresponds to the minimum value and the maximum value of the thickness D of the protective film, is determined by the following equation. The following equations are equations for determining the L* value, the a* value, and the b* value based on the spectral distribution of CIE (International Commission on Illumination) standard light source D65.

[Expression 15]

$$L^* = 116 \times \left(\frac{Y}{100}\right)^{\frac{1}{3}} - 16$$

[Expression 16]

$$a^* = 500 \times \left\{ \left(\frac{X}{95.04}\right)^{\frac{1}{3}} - \left(\frac{Y}{100}\right)^{\frac{1}{3}} \right\}$$

[Expression 17]

$$b^* = 200 \times \left\{ \left(\frac{Y}{100}\right)^{\frac{1}{3}} - \left(\frac{Z}{108.89}\right)^{\frac{1}{3}} \right\}$$

Using the above calculations, the L* value, the a* value, and the b* value obtained when the thickness D of the protective film Pr shown in Fig. 2 is the minimum value; i.e., the L* value, the a* value, and the b* value at the point Mn shown in Fig. 3 are determined. In addition, the L* value, the a* value, and the b* value obtained when the thickness D of the protective film Pr is the maximum value; i.e., the L* value, the a* value, and the b* value at the point Mx shown in Fig. 3 are determined.

Based on the difference between the L* values, the difference between the a* values, and the difference between the b* values at the point Mx and the point Mn shown in Fig. 3, the color difference ΔE is determined by the above equation (I).

<Determination of complex amplitude reflectance $r_{LowE}$ (λ) based on configuration of low-emissive film>

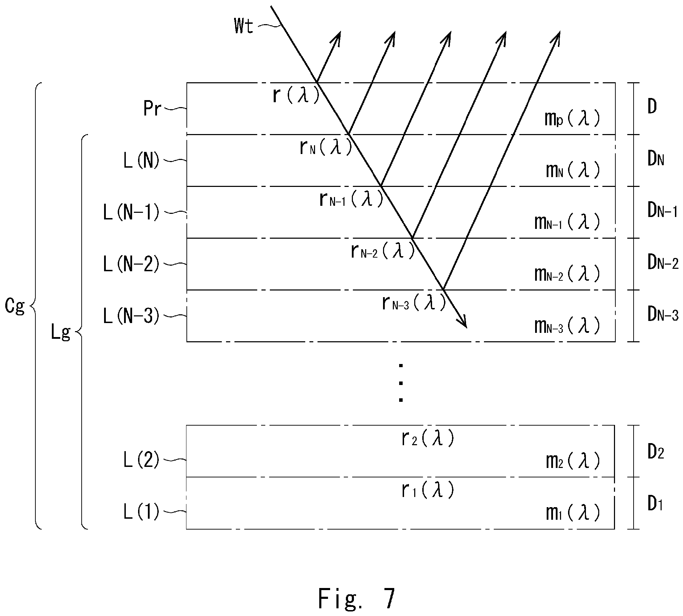

Fig. 7 shows a plane of incidence of the white light Wt that comes in the coated plate glass Cg. In the present embodiment, the complex amplitude reflectance $r_{LowE}$ (λ) of the surface of the laminate Lg is determined by the combination of the thicknesses $D_1$ to $D_N$ of the plate glass and the respective layers in the laminate Lg and the complex indexes of refraction $m_1$ (λ) to $m_N$ (λ). In order to simplify the calculation, the incidence angle and the angle of refraction of light are set to be 0.

[Expression 18]

$$r_{LowE}(\lambda) = r_N(\lambda) = \frac{\frac{m_p(\lambda) - m_N(\lambda)}{m_p(\lambda) + m_N(\lambda)} + r_{N-1}(\lambda) \times e^{i\frac{4\pi m_N(\lambda)}{\lambda}D_N}}{1 + r_{N-1}(\lambda) \times \frac{m_p(\lambda) - m_N(\lambda)}{m_p(\lambda) + m_N(\lambda)} \times e^{i\frac{4\pi m_N(\lambda)}{\lambda}D_N}}$$

[Expression 19]

$$r_{N-1}(\lambda) = \frac{\frac{m_N(\lambda) - m_{N-1}(\lambda)}{m_N(\lambda) + m_{N-1}(\lambda)} + r_{N-2}(\lambda) \times e^{i\frac{4\pi m_{N-1}(\lambda)}{\lambda}D_{N-1}}}{1 + r_{N-2}(\lambda) \times \frac{m_N(\lambda) - m_{N-1}(\lambda)}{m_N(\lambda) + m_{N-1}(\lambda)} \times e^{i\frac{4\pi m_{N-1}(\lambda)}{\lambda}D_{N-1}}}$$

[Expression 20]

$$r_2(\lambda) = \frac{\frac{m_3(\lambda) - m_2(\lambda)}{m_3(\lambda) + m_2(\lambda)} + r_1(\lambda) \times e^{i\frac{4\pi m_2(\lambda)}{\lambda}D_2}}{1 + r_1(\lambda) \times \frac{m_3(\lambda) - m_2(\lambda)}{m_3(\lambda) + m_2(\lambda)} \times e^{i\frac{4\pi m_2(\lambda)}{\lambda}D_2}}$$

[Expression 21]

$$r_1(\lambda) = \frac{\dfrac{m_2(\lambda) - m_1(\lambda)}{m_2(\lambda) + m_1(\lambda)} + \dfrac{m_1(\lambda) - 1}{m_1(\lambda) + 1} \times e^{i\frac{4\pi m_1(\lambda)}{\lambda}D_1}}{1 + \dfrac{m_1(\lambda) - 1}{m_1(\lambda) + 1} \times \dfrac{m_2(\lambda) - m_1(\lambda)}{m_2(\lambda) + m_1(\lambda)} \times e^{i\frac{4\pi m_1(\lambda)}{\lambda}D_1}}$$

$D_N$: Thickness of $N^{th}$ layer L (N) shown in Fig. 2 (nm)
$D_{N-1}$: Thickness of N-$1^{th}$ layer L (N) (nm)
$D_2$: Thickness of second Layer L (2) (nm)
$D_1$: Thickness of plate glass Gs shown in Fig. 2 (nm)
$r_N(\lambda)$: Complex amplitude reflectance on upper surface of $N^{th}$ layer L (N) shown in Fig. 2
$r_{N-1}(\lambda)$: Complex amplitude reflectance on upper surface of N-$1^{th}$ layer L (N-1)
$r_2(\lambda)$: Complex amplitude reflectance on upper surface of second Layer L (2)
$r_1(\lambda)$: Complex amplitude reflectance on upper surface of plate glass. Here, when the plate glass is considered to be a substantially transparent substance, the $r_1(\lambda)$ is a real number.
$m_N(\lambda)$: Complex refractive index of $N^{th}$ layer L (N) shown in Fig. 2
$m_{N-1}(\lambda)$: Complex refractive index of N-$1^{th}$ layer L (N-1)
$m_2(\lambda)$: Complex refractive index of second Layer L (2)

$$m_N(\lambda) = n_N(\lambda) + ik_N(\lambda)$$

$n_N(\lambda)$: Function of refractive index of $N^{th}$ layer with respect to light having wavelength $\lambda$
$n_{N-1}(\lambda)$: Function of refractive index of N-$1^{th}$ layer with respect to light having wavelength $\lambda$
$n_2(\lambda)$: Function of refractive index of second layer with respect to light having wavelength $\lambda$
$k_N(\lambda)$: Extinction coefficient of $N^{th}$ layer with respect to light having wavelength $\lambda$
$k_{N-1}(\lambda)$: Function of extinction coefficient of N-$1^{th}$ layer with respire to light having wavelength $\lambda$
$k_2(\lambda)$: Function of extinction coefficient of second layer with respect to light having wavelength $\lambda$

The refractive index and the extinction coefficient of each layer are physical property values determined by the conductive metal or the dielectric constituting each layer.

$m_1(\lambda)$: Complex refractive index of plate glass Gs shown in Fig. 2

$$m_1(\lambda) = n_1(\lambda) + ik_1(\lambda)$$

$n_1(\lambda)$: Refractive index of plate glass Gs with respect to light having wavelength $\lambda$
$k_1(\lambda)$: Extinction coefficient of plate glass Gs with respect to light having wavelength $\lambda$

The refractive index and the extinction coefficient of the plate glass Gs are physical property values and may be assumed to be constant regardless of the wavelength $\lambda$.

When the plate glass Gs shown in Fig. 2 is formed of soda glass, the value of the complex amplitude reflectance of the plate glass Gs may be assumed to be 0.209 + 2.05 × 10$^{-7}$i, where i is an imaginary unit.

When one layer constituting the low-emissive film Le shown in Fig. 2 is formed of a metal such as silver (Ag), the refractive index of the layer may be assumed to have a value of 0.135 regardless of the wavelength. In addition, the extinction coefficient of the layer may be assumed to have a value of 3.985 regardless of the wavelength.

When one layer constituting the low-emissive film Le shown in Fig. 2 is formed of a dielectric such as silicon nitride, the refractive index of the layer may be assumed to have a value of 2.023 regardless of the wavelength. In addition, the extinction coefficient of the layer may be assumed to have a value of 0.00 regardless of the wavelength.

Moreover, the color difference $\Delta E$ on the coated surface Cs shown in Fig. 3 is determined. As described in the above <Tolerance and color difference $\Delta E$ of thicknesses of protective film>, this value is based on the complex amplitude reflectance $r_{LowE}(\lambda)$, the minimum limit size Ls of the thickness D of the protective film, and the sum of the minimum limit size Ls and the tolerance Tr; i.e., the maximum limit size.

<Simulation>

The simulation is performed by using the calculations shown in <Determination of complex amplitude reflectance $r_{LowE}(\lambda)$ from configuration of low-emissive film> and <Tolerance and color difference $\Delta E$ of thicknesses of protective film>

First, the following functions are previously determined. The functions may be a constant value regardless of the wavelength.

· Refractive index $n_1(\lambda)$ of plate glass Gs shown in Fig. 2
· Extinction coefficient $k_1(\lambda)$ of plate glass Gs
· Refractive index and extinction coefficient are determined by the composition of the plate glass Gs.
· Thickness $D_1$ (nm) of plate glass Gs
· Complex amplitude reflectance $r_1(\lambda)$ on upper surface of plate glass Gs
· Number of layers N of laminate composed of low-emissive film Le and plate glass
· From refractive index $n_2(\lambda)$ of second Layer L (2) to refractive index $n_N(\lambda)$ of $N^{th}$ layer L
· From extinction coefficient $k_2(\lambda)$ of second Layer L (2) to extinction coefficient $k_n(\lambda)$ of $N^{th}$ layer L (N)
· The refractive index and the extinction coefficient are determined by the composition of each layer.
· Refractive index $n_p(\lambda)$ of protective film Pr
· Extinction coefficient $k_p(\lambda)$ of protective film Pr
· The refractive index and the extinction coefficient are determined by the composition of the protective film Pr.

Next, the following conditions are determined.
· The incidence angle of light at the boundaries of each layer of the low-emissive film Le and the protective film Pr shown in Fig. 2, for example, incidence angle = 0
· Refractive index of air $n_{air}$, for example, $n_{air}$ = 0
· Spectral distribution $S(\lambda)$ of standard illuminant, for example, spectral distribution of CIE (International Commission on Illumination) standard light source D65
· Color-matching functions $x^-(\lambda)$, $y^-(\lambda)$, and $z^-(\lambda)$, for example, CIE (International Commission on Illumination) color-matching functions
· Determination of tristimulus values X, Y, and Z by approximate equation or regardless of approximate equation
· Upper limit and lower limit of wavelength, for example, lower limit of 380 nm and upper limit of 730 nm
· Interval $d\lambda$ of wavelength, for example, 10 nm

Next, the changes in the numerical values assigned to the following variables are determined within the numerical range set for each variable. The numerical value may be changed by random numbers obtained on a computer. The random numbers may be obtained by a pseudo-random number sequence or a true random number sequence. It also determines the changes in the combination of these numbers.

· Thickness $D_1$ (nm) of plate glass Gs shown in Fig. 2. Note that, $D_1$ may be constant.
· From thickness $D_2$ (nm) of second Layer L (2) to thickness $D_N$ (nm) of $N^{th}$ layer L (N) of low-emissive film Le
· Minimum limit size Ls of thickness of protective film Pr shown in Fig. 3, the minimum limit size Ls may be constant.
· Sum of minimum limit size Ls and tolerance Tr of protective film Pr; i.e., maximum limit size of thickness of protective film Pr, the maximum limit size may be constant.

The simulation is performed by assigning a change in the combination of the above numerical values [$D_1$, $D_2 \cdots D_N$, Ls, and (Ls + Tr)] to each of the variables of the calculation equations shown in <Determination of complex amplitude reflectance $r_{LowE}(\lambda)$ from configuration of low-emissive film> and <Tolerance and color difference $\Delta E$ of thicknesses of protective film>.

From the results of the simulation, the combination of the thickness $D_1$ of the plate glass Gs and the thicknesses $D_2$ to $D_N$ of the respective layers of the low-emissive film Le shown in Fig. 2 with the minimum limit size Ls and the tolerance Tr of the protective film Pr shown in Fig. 3 is selected. That is, a combination of variables [$D_1$, $D_2 \cdots D_N$, Ls, and (Ls + Tr)], in which $\Delta E$ satisfies the predetermined range, for example, $0 < \Delta E < 3.5$, is selected. Based on the selected combination of numerical values, the coated plate glass Cg is prepared. Regarding the simulation, at least any variables of the thickness of the plate glass Gs shown in Fig. 2 and the minimum limit size Ls and the tolerance Tr of the protective film Pr shown in Fig. 3 may be previously set to one value.

<Configuration of low-emissive film>

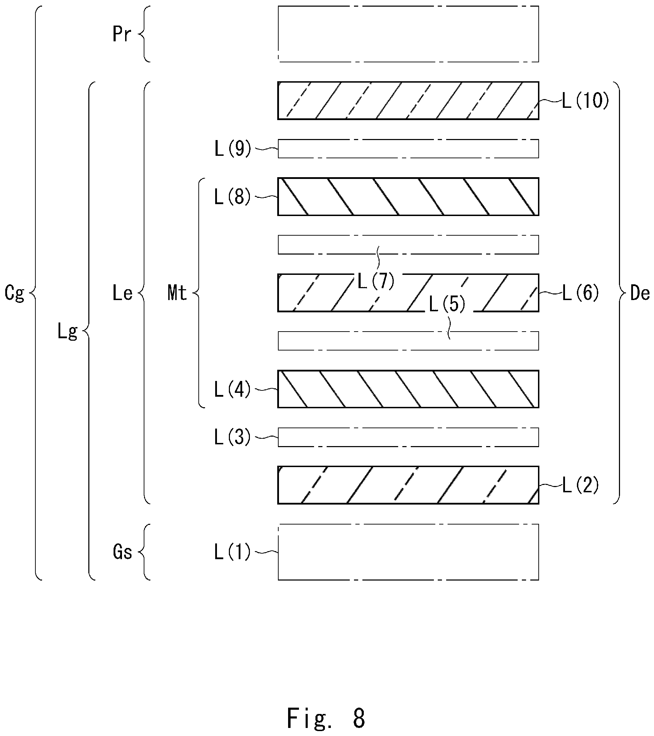

Fig. 8 shows a cross section of the exploded low-emissive film Le. The low-emissive film Le shown in this figure is an example. As shown in the above-described simulation, the number of layers in the low-emissive film Le and the compositions of these layers can be determined if necessary.

It includes a plurality of dielectric layers De shown in Fig. 8. The dielectric layer De includes Layers L (2), L (6), and L (10) formed of the dielectric. The low-emissive film Le exemplified in the figure includes one or more metallic layers Mt. The metallic layer Mt includes a conductive metal, for example, Layer L (4) formed of silver (Ag). The metallic layer Mt includes Layer L (8) formed of a conductive metal, for example, silver (Ag), in addition to the Layer L (4).

The materials and the complex refractive index of the dielectric and the conductive metal are described above. One example of the thickness of the metallic layer is from 1 to 30 nm, and preferably from 5 to 20 nm. The thickness of the dielectric layer is, for example, from 10 to 70 nm, and preferably from 10 to 50 nm, in the Layers L (2) and L (10), and is from 10 to 120 nm, and preferably from 15 to 100 nm in the Layer L (6).

The Layer L (2) shown in Fig. 8 is positioned between the surface of the plate glass Gs; i.e., the Layer L (1) and the Layer L (4) that is one of metallic layers Mt. In this embodiment, the Layer L (2) may be referred to as the first dielectric layer. The Layer L (6) is positioned between the Layer L (4) and the surface of the protective film Pr. In this embodiment, the Layer L (6) may be referred to as the second dielectric layer. The dielectric layer De includes the first dielectric layer and the second dielectric layer.

The low-emissive film Le shown in Fig. 8 includes a plurality of buffer layers. The buffer layer includes Layers L (3), L (5), L (7), and L (9). The Layer L (3) is positioned between the Layer L (2) as the first dielectric layer and the Layer L (4) that is one of the metallic layers Mt. The Layer L (3) may be referred to as the first buffer layer. The Layer L (5) is positioned between the Layer L (4) and the Layer L (6) as the second dielectric layer. The Layer L (5) may be referred to as the second buffer layer.

Examples of materials of the composition constituting the buffer layer include metal simple substances selected from Ni, Cr, Cu, Al, Pd, W, Mo, Ti, Nb, and Ta and alloys thereof, and nitrides of the metal simple substances or nitrides of the alloys, or those obtained by doping the metal simple substance or the alloy with another metal. Preferable examples thereof include metal simple substances selected from Ni, Cr, W, Ti, and Nb or alloys thereof, nitrides of the metal simple substance or nitrides of the alloys, or those obtained by doping the metal simple substance or the alloy with another metal.

One example of the thickness of the buffer layer is from 1 to 20 nm, and preferably from 1 to 10 nm. As one example of the complex refractive index of light having a wavelength of 590 nm of the buffer layer, the refractive index is from 0.20 to 3.80, and the extinction coefficient is from 1.80 to 7.20.

The Layer L (3) shown in Fig. 8 is formed of the above composition having a predetermined refractive index, for example, a nickel-chromium alloy (NiCr). The refractive index of the Layer L (3) is higher than the refractive index of the Layer L (2) and the refractive index of the Layer L (4). The Layer L (3) is thinner than the Layer L (2). The Layer L (9) is formed of a composition having a predetermined refractive index, for example, a nickel-chromium alloy (NiCr). The refractive index of the Layer L (5) is higher than the refractive index of the Layer L (4) and the refractive index of the Layer L (6). The Layer L (5) is thinner than the Layer L (6).

The Layer L (8) that is one of the metallic layers Mt shown in Fig. 8 is positioned between the Layer L (6) and the protective film Pr. The Layer L (4) may be referred to as the first metallic layer. The Layer L (8) may be referred to as the second metallic layer. The Layer L (10) is positioned between the Layer L (8) and the protective film Pr. The Layer L (10) may be referred to as the third dielectric layer.

As shown in Fig. 8, each layer in the dielectric layer De and each layer in the metallic layer Mt are adjacent to each other, and are connected with the Layers L (3), L (5), L (7), and L (9) that function as the buffer layer. Each buffer layer is formed of a composition having a higher refractive index than the dielectric layer De and the metallic layer Mt connected by the buffer layer, for example, nickel-chromium alloy (NiCr). In one embodiment, each buffer layer is thinner than each dielectric layer. In one embodiment, each buffer layer is thinner than each metallic layer.

In one embodiment shown in Fig. 8, the low-emissive film Le includes the following nine layers, from the protective film Pr toward the plate glass Gs.

Layer L (10)_third dielectric layer__thickness of from 10 to 70 nm
Layer L (9)__buffer layer__thickness of from 1 to 20 nm
Layer L (8)__second metallic layer___thickness of from 1 to 30 nm
Layer L (7)__buffer layer__thickness of from 1 to 20 nm
Layer L (6)__second dielectric layer__thickness of from 10 to 120 nm
Layer L (5)__buffer layer__thickness of from 1 to 20 nm
Layer L (4)__first metallic layer___thickness of from 1 to 30 nm
Layer L (3)__buffer layer__thickness of from 1 to 20 nm

Layer L (2)__first dielectric layer__thickness of from 10 to 70 nm

In another embodiment shown in Fig. 8, the low-emissive film Le includes the following nine layers, from the protective film Pr toward the plate glass Gs.

Layer L (10)_third dielectric layer__thickness of from 10 to 45 nm
Layer L (9)__buffer layer__thickness of from 1 to 9 nm
Layer L (8)__second metallic layer___thickness of from 5 to 20 nm
Layer L (7)__buffer layer__thickness of from 1 to 9 nm
Layer L (6)__second dielectric layer__thickness of from 51 to 99 nm
Layer L (5)__buffer layer__thickness of from 1 to 9 nm
Layer L (4)__first metallic layer___thickness of from 8 to 20 nm
Layer L (3)__buffer layer__thickness of from 1 to 9 nm
Layer L (2)__first dielectric layer__thickness of from 16 to 48 nm

In another embodiment shown in Fig. 8, the low-emissive film Le includes the following nine layers, from the protective film Pr toward the plate glass Gs.
Layer L (10)_third dielectric layer__thickness of from 10 to 45 nm
Layer L (9)__buffer layer__thickness of from 1 to 9 nm
Layer L (8)__second metallic layer___thickness of from 12 to 20 nm
Layer L (7)__buffer layer__thickness of from 1 to 9 nm
Layer L (6)__second dielectric layer__thickness of from 51 to 99 nm
Layer L (5)__buffer layer__thickness of from 5 to 9 nm
Layer L (4)__first metallic layer___thickness of from 8 to 12 nm
Layer L (3)__buffer layer__thickness of from 1 to 9 nm
Layer L (2)__first dielectric layer__thickness of from 16 to 48 nm

In another embodiment shown in Fig. 8, the low-emissive film Le includes the following nine layers, from the protective film Pr toward the plate glass Gs.

Layer L (10)_third dielectric layer__thickness of from 10 to 45 nm
Layer L (9)__buffer layer__thickness of from 1 to 9 nm
Layer L (8)__second metallic layer___thickness of from 5 to 18nm
Layer L (7)__buffer layer__thickness of from 1 to 9 nm
Layer L (6)__second dielectric layer__thickness of from 51 to 99 nm
Layer L (5)__buffer layer__thickness of from 1 to 9 nm
Layer L (4)__first metallic layer___thickness of from 12 to 20 nm
Layer L (3)__buffer layer__thickness of from 1 to 9 nm
Layer L (2)__first dielectric layer__thickness of from 16 to 48 nm

In another embodiment, the low-emissive film Le includes the following three layers, from the protective film Pr toward the plate glass Gs.
Layer L (6)__second dielectric layer__thickness of from 10 to 120 nm
Layer L (4)__first metallic layer___thickness of from 1 to 30 nm
Layer L (2)__first dielectric layer__thickness of from 10 to 70 nm

Moreover, in another embodiment, the low-emissive film Le includes the following five layers, from the protective film Pr toward the plate glass Gs.
Layer L (6)__second dielectric layer__thickness of from 10 to 120 nm
Layer L (5)__buffer layer__thickness of from 1 to 20 nm
Layer L (4)__first metallic layer___thickness of from 1 to 30 nm

Layer L (3)__buffer layer__thickness of from 1 to 20 nm
Layer L (2)__first dielectric layer__thickness of from 10 to 70 nm

In another embodiment, the low-emissive film Le includes the following seven layers, from the protective film Pr toward the plate glass Gs.
Layer L (10)_third dielectric layer__thickness of from 10 to 70 nm
Layer L (9)__buffer layer__thickness of from 1 to 20 nm
Layer L (6)__second dielectric layer__thickness of from 10 to 120 nm
Layer L (5)__buffer layer__thickness of from 1 to 20 nm
Layer L (4)__first metallic layer___thickness of from 1 to 30 nm
Layer L (3)__buffer layer__thickness of from 1 to 20 nm
Layer L (2)__first dielectric layer__thickness of from 10 to 70 nm

<Production method of coated plate glass>

A method for producing the coated plate glass Cg will be described using, as an example, a case in which the coated plate glass Cg includes the low-emissive film Le formed of five layers.
The method includes:

a step of placing a first dielectric layer De on a plate glass Gs;
a step of placing a first buffer layer on the first dielectric layer;
a step of placing a metallic layer Mt on the first buffer layer;
a step of placing a second buffer layer on the metallic layer;
a step of placing a second dielectric layer De on the second buffer layer; and
a step of placing a silica-based protective film Pr on the second dielectric layer.

Methods for placing the first dielectric layer, the first buffer layer, the metallic layer, the second buffer layer, and the second dielectric layer are not particularly limited, and a film can be formed using any conventional film formation method. For example, when an inline-type sputtering apparatus is used, a film of the dielectric layer is formed through reactive AC sputtering under an atmosphere including an inert gas such as argon and an active gas such as nitrogen. Films of the buffer layer and the metallic layer are formed through DC sputtering under an argon atmosphere.
A method for placing the silica-based protective film Pr is not particularly limited, and the film thereof is formed by any conventional film formation method such as roll coating or die coating. Regarding coating, after a step of placing the protective film Pr using a sol-gel silica liquid having a solid content concentration of about 2 to 5%, a step of heat-treating the coated plate glass Cg may be performed if necessary. The heat treatment is performed by maintaining the coated plate glass Cg in an atmosphere, for example, at 100 to 700°C for two minutes to an hour.

<Selection of hue>

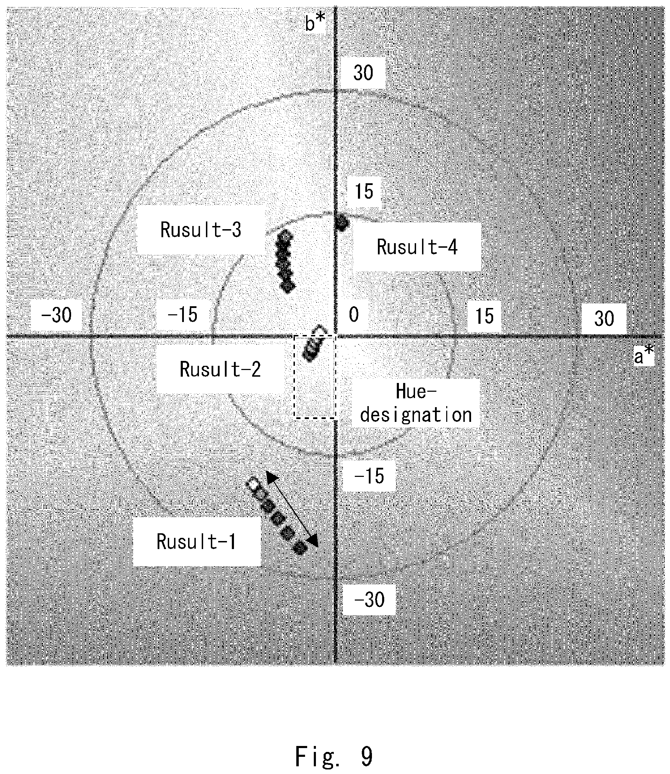

Fig. 9 shows the results of the simulation using a two-dimensional coordinate system of the a* value and the b* value. The low-emissive film includes the following nine layers from the protective film toward the plate glass. The graph includes four representative results of simulations: Result-1 to Result-4. In the Result-1, diamond-shaped plots form a row along the double-headed arrow. This row shows the variation in the thickness of the protective film within the tolerance range, that is, the variation in hue due to the variation in deviation. Each diamond plot corresponds to each value of the thickness of the protective film.
In Fig. 9, in the Result-2 and the Result-4, each $\Delta E$ falls within a predetermined range, for example, $0<\Delta E<3.5$. In the Result-1 and the Result-3, each $\Delta E$ is outside this range.
In Fig. 9, a result with a preferable hue is further selected from the set consisting of the Result-2 and the Result-4. The rectangle indicated by the dashed line near the origin of the third quadrant is the range in which the a* value is -15 or more, preferably -10 or more and 0 or less, and the b* value is -20 or more and 0 or less, which may be referred to as hue designation. The Result-2 satisfies the hue designation. Note that, some of the variation of the hue in the Result-2 exceeds the hue designation. Therefore, the simulation may be performed again to obtain a result in which the entire variation of hue satisfies the hue designation.
Based on the combination of variables that results in the Result-2 shown in Fig. 9, the coated plate glass is prepared. On the coated surface, the hue as shown in the hue designation is observed, as is relatively seen. The hue designation shown in the figure shows glass that strongly reflects a blue hue, but has a high visible light transmittance. By setting the a* value and the b* value to other ranges, other hue designations can be obtained. Such hue designations may also be used.

<Application>

An approach for determining the thickness of each layer based on the results obtained from the above simulation can be applied to the design and production of various coated plate glasses. This approach is particularly useful for coated plate glass in which the protective film is formed through roll coating, die coating, or spray coating.

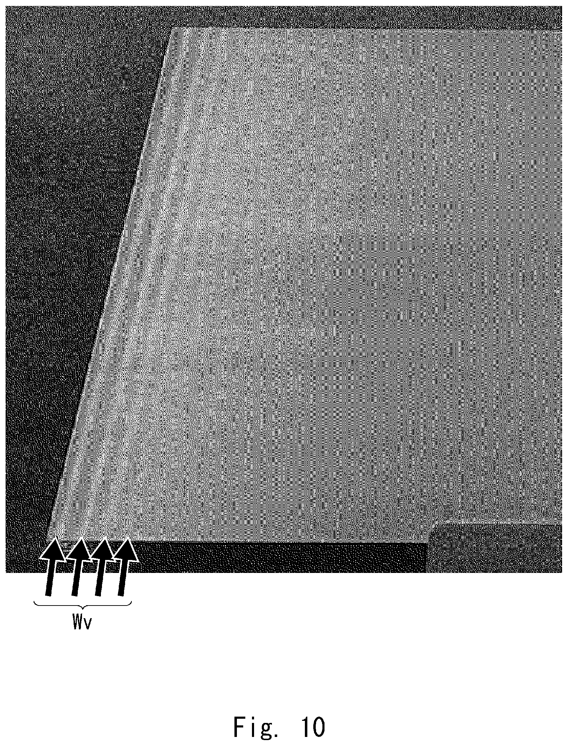

Fig. 10 shows changes in thickness on the coated surface when the silica-based protective film is formed on a plate glass through roll coating, using light and shade of color. It is often seen that the protective film of plate glass has waviness Wv, particularly near the rise of the roll coating. The waviness Wv appears as unevenness in the cross section of the protective film Pr shown in Fig. 3.

In the above simulation, even when the thickness of the protective film Pr has a deviation as shown in Fig. 3, such design that ΔE on the coated surface falls within the predetermined range can be provided. This design includes the specification of the minimum limit size Ls of the protective film Pr and the thicknesses $D_N$, $D_{N-1}$···$D_2$ of the respective layers of the low-emissive film Le and the thickness $D_1$ of the plate glass shown in Fig. 2.

<Supplement of maximum color difference>

As shown in Fig. 3, the color difference ΔE between the point Mx that is the maximum thickness of the protective film Pr and the point Mn that is the minimum thickness of the protective film Pr is the maximum color difference ΔE on the coated surface. Here, the possibility that the color difference ΔE between the hue at the point Mn and the hue at a point where the thickness of the protective film Pr has an intermediate value is the maximum color difference ΔE on the coated surface will be considered.

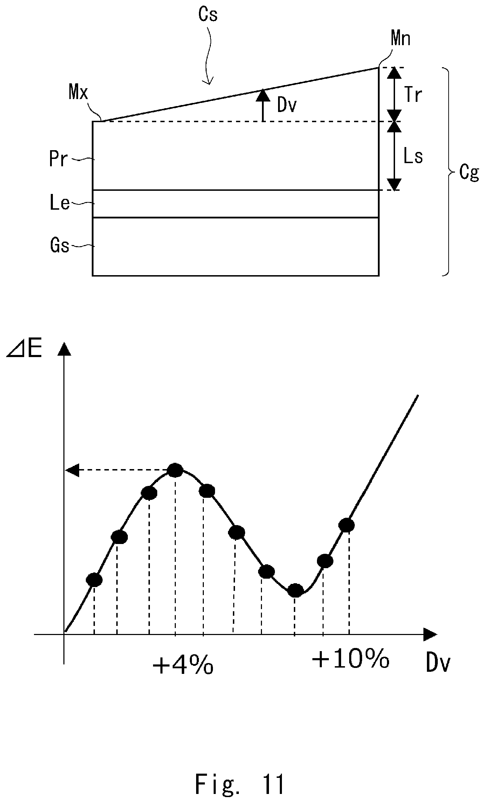

The upper row of Fig. 11 shows the side surface of the modeled coated plate glass Cg. The graph shown in the lower row shows an example of a change in the color difference ΔE with respect to the deviation Dv of the thickness of the protective film. In this embodiment, the maximum value of the deviation Dv of the thickness of the protective film Pr is 10% of the minimum limit size of the protective film Pr. That is, the tolerance of the thickness is 10% of the minimum limit size.

As shown in Fig. 11, as the deviation Dv increases by 1 point (%), the color difference ΔE between a hue at a point Mn where the deviation Dv is 0 and a hue at a point where the deviation Dv is greater than 0 is simulated. The graph exemplifies one of results in the simulation. In the graph, the color difference ΔE is maximum at a point where the deviation Dv is 4% of the m minimum limit size Ls. The color difference ΔE is larger than the color difference ΔE between the hue at the point Mn where the deviation Dv is 0 and the hue at the point Mx where the deviation Dv is 10%.

However, in Fig. 11, the present inventors confirmed that as long as the minimum limit size Ls of the thickness of the protective film Pr does not exceed approximately 500 nm, the color difference ΔE between the hue at the point Mn and the hue at the point Mx becomes maximum in all simulation results. The ranges of the thickness of the protective film, the thickness of each layer of the low-emissive film, and the thickness of the plate glass are as follows.

Protective film_____larger than thickness of 25 mm
Layer L (10)_third dielectric layer__thickness of from 10 to 50 nm
Layer L (9)__buffer layer__thickness of from 0.5 to 20 nm
Layer L (8)__second metallic layer___thickness of from 5 to 30 nm
Layer L (7)__buffer layer__thickness of from 0.5 to 20 nm
Layer L (6)__second dielectric layer__thickness of from 10 to 100 nm
Layer L (5)__buffer layer__thickness of from 0.5 to 20 nm
Layer L (4)__first metallic layer___thickness of from 5 to 30 nm
Layer L (3)__buffer layer__thickness of from 0.5 to 20 nm
Layer L (2)__first dielectric layer__thickness of from 10 to 50 nm
Layer L (1)__plate glass_____thickness of 3 mm

* See Fig. 7 for Layer L (1) to L (10)

Based on the above, the minimum limit size Ls of the thickness of the protective film Pr is from 0 to 500 nm. The upper limit of the minimum limit size Ls may be 50, 75, 100, 150, 200, 300, or 400nm. The lower limit of the minimum limit size Ls may be 25, 50, 75, 100, 150, 200, or 300 nm.

<Inspection of product>

For example, the following inspection approaches can confirm that a configuration of the produced coated plate glass is as designed:

A. The constituent elements of the protective film are analyzed in the depth direction from the surface of the protective film using X-ray photoelectron spectroscopy (XPS).

B. The thickness of the protective film is identified by investigating the cross section of the protective film using a combination of a scanning electron microscope (SEM) and energy dispersive X-ray spectroscopy (EDX).

C. The protective film is removed by etching. Moreover, while each layer in the low-emissive film is removed one by one, properties of each layer are measured. Examples of the properties include reflectance, transmittance, film thickness, and refractive index. The film thickness and the refractive index can be measured by an ellipsometer.

D. Based on the calculated values obtained in A to C, the refractive index and the complex refractive index of each layer are identified using optical simulation.

**Examples**

<Example 1> Simulations of 6,000 patterns

The combinations of the minimum limit size of the protective film, and thicknesses of the Layer L (2) to the Layer L (10) in the low-emissive film and the Layer L (1) formed of the plate glass within the following ranges were randomly changed using random numbers. Six thousand patterns of this combination were obtained. Based on the combination of the thicknesses of each pattern, the set of the L* value, the a* value, and the b* value in the L*a*b* color system was further determined.

Pprotective film_____thickness of from 25 to 75 mm
Layer L (10)_third dielectric layer__thickness of from 10 to 50 nm
Layer L (9)__buffer layer__thickness of from 0.5 to 9.5 nm
Layer L (8)__second metallic layer___thickness of from 12 to 20 nm
Layer L (7)__buffer layer__thickness of from 0.5 to 9.5 nm
Layer L (6)__second dielectric layer__thickness of from 50 to 100 nm
Layer L (5)__buffer layer__thickness of from 0.5 to 9.5 nm
Layer L (4)__first metallic layer___thickness of from 8 to 12 nm
Layer L (3)__buffer layer__thickness of from 0.5 to 9.5 nm
Layer L (2)__first dielectric layer__thickness of from 10 to 50 nm
Layer L (1)__plate glass_____thickness of 3 mm

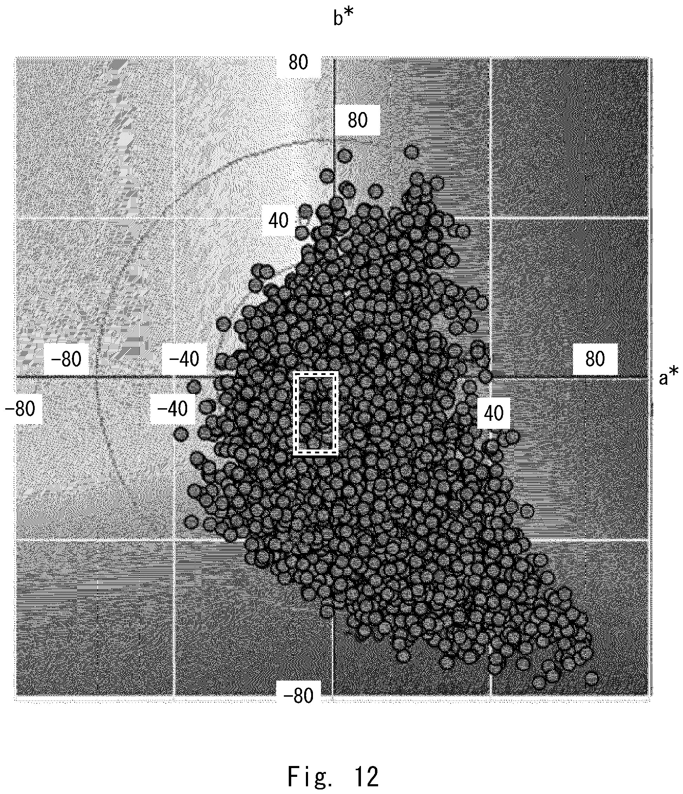

Fig. 12 shows the a* and b* values of 6,000 patterns plotted on a two-dimensional coordinate system. Each dot corresponds to each pattern. The dashed rectangle near the origin of the third quadrant indicates the hue designation, that is, the range in which the a* value is -10 or more and 0 or less, and the b* value is -20 or more and 0 or less. The difference from Fig. 9 is that the calculation results obtained by varying the deviation of the thickness of the protective film are not shown in this coordinate system. Among the 6,000 patterns, there is a pattern that has a desired hue designation. The ranges of the thickness of the protective film, the thickness of each layer of the low-emissive film, and the thickness of the plate glass are as follows.

Furthermore, the thickness of the protective film was changed to the minimum limit size plus a 10% tolerance, that is, the maximum limit size, and 6,000 patterns of sets of L* values, a* values, and b* values were determined again. Six thousand patterns of color difference ΔE were obtained when the thickness of the protective film was changed by the tolerance.

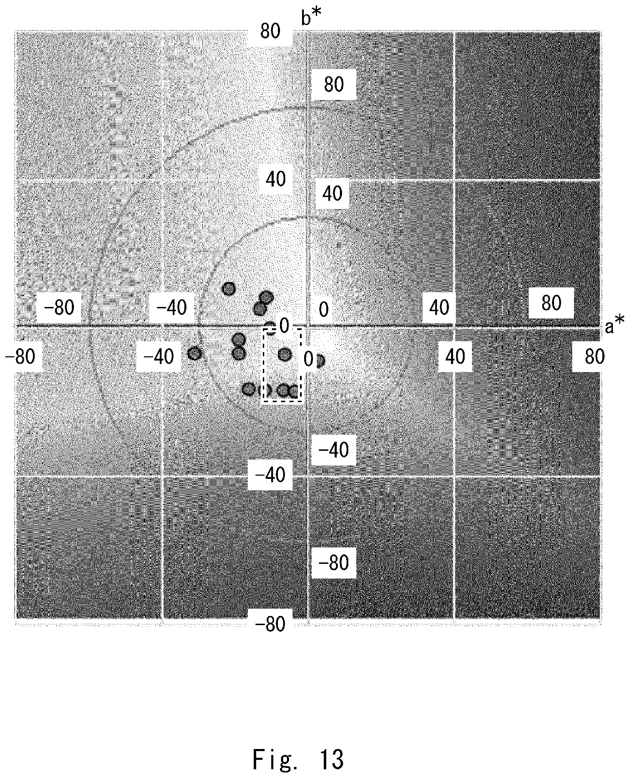

As shown in Fig. 13, 13 patterns in which the color difference ΔE<1 was satisfied were extracted from 6,000 patterns. These patterns were plotted in the two-dimensional coordinate system. The thicknesses of the protective film, each layer of the low-emissive film, and the plate glass in each pattern are shown below. Several patterns that satisfied the hue designation were found.

Table 2 shows the combinations of the thicknesses of 13 patterns. Note that, "+ tolerance" in Table 2 represents "minimum limit size + tolerance".

[Table 2]

| Layers in low-emissive film | | | | | | | | | Protective film | | Color difference ΔE |
|---|---|---|---|---|---|---|---|---|---|---|---|
| L (10) | L (9) | L (8) | L (7) | L (6) | L (5) | L (4) | L (3) | L (2) | | | |
| Third dielectric | Buffer | Second metal | Buffer | Second dielectric | Buffer | First metal | Buffer | First dielectric | Minimum limit size | + Tolerance | |
| 26 | 7 | 17 | 1 | 88 | 6 | 8 | 2 | 13 | 25 | 27.5 | **0.90** |
| 42 | 3 | 17 | 9 | 94 | 5 | 10 | 6 | 10 | 25 | 27.5 | **0.96** |
| 39 | 5 | 18 | 2 | 96 | 2 | 11 | 2 | 16 | 27 | 29.7 | **0.95** |
| 47 | 3 | 20 | 6 | 94 | 8 | 10 | 5 | 14 | 25 | 27.5 | **0.94** |
| 44 | 8 | 20 | 3 | 78 | 7 | 11 | 7 | 10 | 25 | 27.5 | **0.94** |
| 45 | 7 | 15 | 2 | 95 | 9 | 11 | 3 | 16 | 27 | 29.7 | **0.93** |
| 43 | 3 | 14 | 4 | 92 | 8 | 11 | 1 | 10 | 28 | 30.8 | **0.98** |
| 25 | 9 | 20 | 3 | 98 | 8 | 9 | 3 | 14 | 27 | 29.7 | **0.88** |
| 28 | 5 | 20 | 8 | 87 | 7 | 8 | 1 | 11 | 25 | 27.5 | **0.94** |
| 44 | 9 | 16 | 1 | 84 | 6 | 9 | 5 | 10 | 27 | 29.7 | **0.98** |
| 44 | 7 | 17 | 6 | 95 | 6 | 8 | 2 | 18 | 25 | 27.5 | **0.93** |
| 32 | 4 | 20 | 7 | 88 | 5 | 8 | 2 | 12 | 25 | 27.5 | **0.98** |
| 48 | 7 | 16 | 3 | 95 | 6 | 8 | 2 | 12 | 25 | 27.5 | **0.86** |

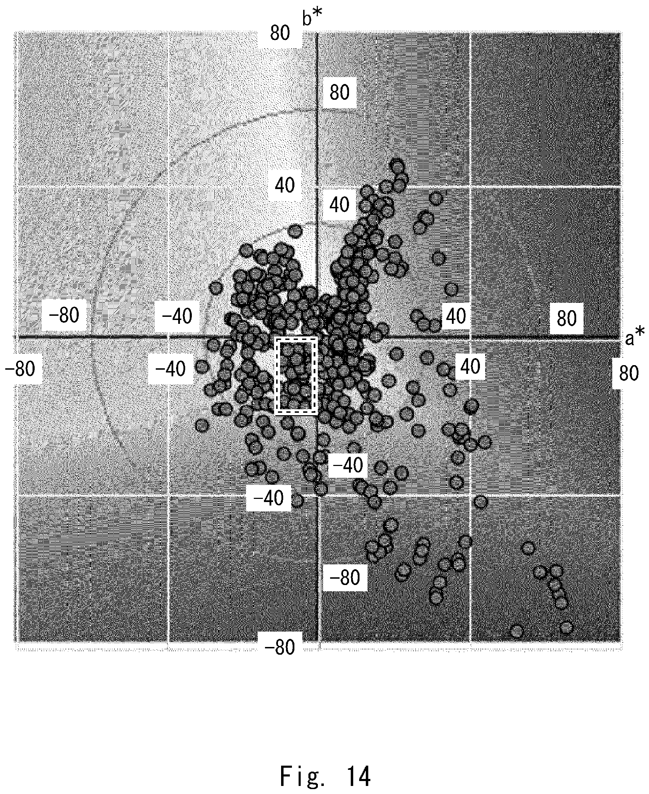

As shown in Fig. 14, 482 patterns in which the color difference ΔE<2 was satisfied were extracted from 6,000 patterns. These patterns were plotted in the two-dimensional coordinate system. Several patterns that satisfied the hue designation were found.

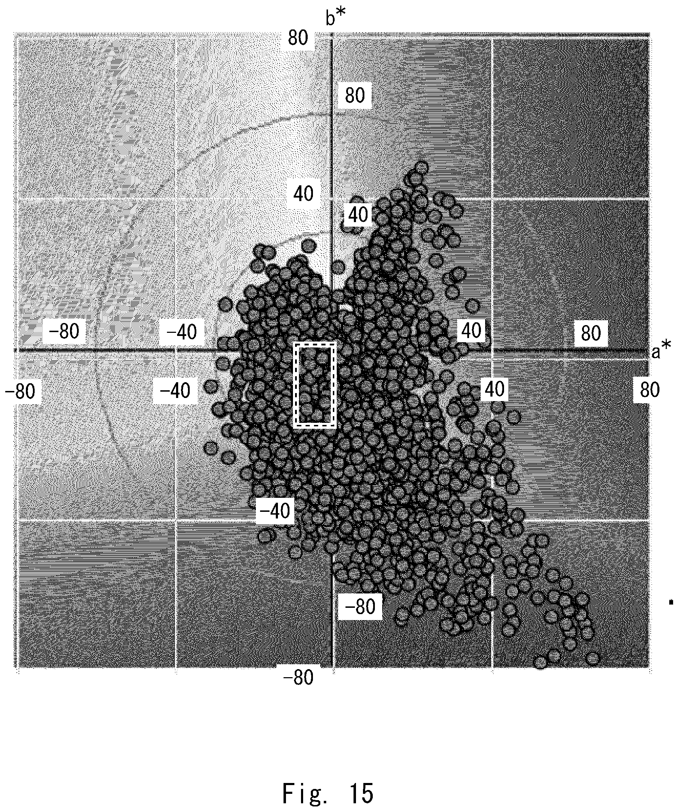

As shown in Fig. 15, 1,949 patterns in which the color difference ΔE<3.5 was satisfied were extracted from 6,000 patterns. These patterns were plotted in the two-dimensional coordinate system.

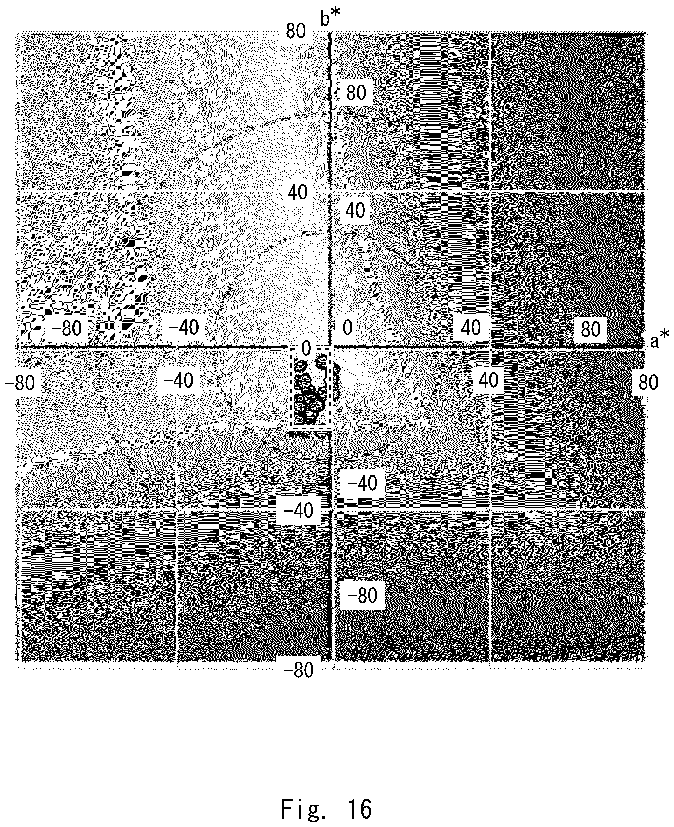

Fig. 16 represents plots obtained by extracting, from 1,949 patterns, 24 patterns that satisfied the range of the hue designation: the a* value is -10 or more and 0 or less, and the b* value is -20 or more and 0 or less.

Table 3 shows the combinations of the thicknesses of 24 patterns. Note that, "+ tolerance" in Table 3 represents "minimum limit size + tolerance".

[Table 3]

| Layers in low-emissive film | | | | | | | | | Protective film | | Color difference ΔE |
| L (10) | L (9) | L (8) | L (7) | L (6) | L (5) | L (4) | L (3) | L (2) | | | |
| Third dielectric | Buffer | Second metal | Buffer | Second dielectric | Buffer | First metal | Buffer | First dielectric | Minimum limit size | + Tolerance | |
|---|---|---|---|---|---|---|---|---|---|---|---|
| 17 | 8 | 14 | 8 | 51 | 8 | 12 | 2 | 48 | 52 | 57.2 | **3.34** |
| 45 | 8 | 18 | 7 | 95 | 9 | 11 | 7 | 30 | 63 | 69.3 | **3.03** |
| 43 | 4 | 18 | 2 | 58 | 5 | 8 | 4 | 47 | 52 | 57.2 | **2.94** |
| 38 | 1 | 20 | 8 | 98 | 8 | 10 | 4 | 26 | 62 | 68.2 | **3.13** |
| 40 | 5 | 17 | 8 | 95 | 6 | 12 | 7 | 24 | 72 | 79.2 | **3.27** |
| 39 | 9 | 13 | 8 | 92 | 8 | 8 | 9 | 21 | 74 | 81.4 | **3.19** |
| 38 | 3 | 19 | 6 | 91 | 6 | 11 | 9 | 28 | 68 | 74.8 | **3.47** |
| 42 | 1 | 20 | 6 | 96 | 8 | 11 | 8 | 30 | 58 | 63.8 | **3.18** |
| 25 | 4 | 12 | 4 | 51 | 9 | 12 | 1 | 48 | 55 | 60.5 | **3.44** |
| 29 | 4 | 20 | 3 | 90 | 8 | 10 | 7 | 30 | 51 | 56.1 | **3.40** |
| 11 | 4 | 18 | 6 | 95 | 9 | 12 | 7 | 21 | 71 | 78.1 | **3.07** |
| 33 | 4 | 17 | 8 | 61 | 7 | 8 | 3 | 48 | 54 | 59.4 | **3.48** |
| 33 | 3 | 15 | 1 | 98 | 9 | 12 | 7 | 21 | 74 | 81.4 | **3.07** |
| 37 | 1 | 19 | 7 | 99 | 9 | 8 | 5 | 32 | 52 | 57.2 | **3.31** |
| 27 | 4 | 15 | 7 | 61 | 5 | 9 | 4 | 50 | 51 | 56.1 | **3.06** |
| 37 | 7 | 17 | 8 | 99 | 7 | 11 | 9 | 35 | 52 | 57.2 | **3.04** |
| 20 | 8 | 13 | 4 | 90 | 9 | 10 | 8 | 16 | 75 | 82.5 | **3.28** |
| 37 | 4 | 12 | 8 | 98 | 7 | 8 | 9 | 27 | 64 | 70.4 | **3.39** |
| 42 | 4 | 15 | 6 | 98 | 8 | 11 | 9 | 26 | 67 | 73.7 | **3.20** |
| 23 | 7 | 19 | 9 | 94 | 5 | 9 | 9 | 25 | 65 | 71.5 | **3.43** |
| 44 | 6 | 15 | 8 | 93 | 7 | 11 | 9 | 23 | 66 | 72.6 | **3.33** |
| 29 | 3 | 14 | 5 | 96 | 8 | 9 | 8 | 32 | 65 | 71.5 | **3.49** |
| 42 | 1 | 12 | 2 | 90 | 8 | 11 | 8 | 21 | 72 | 79.2 | **3.44** |
| 10 | 8 | 19 | 3 | 86 | 8 | 12 | 7 | 17 | 72 | 79.2 | **3.01** |

EP 4 501 877 A1

It was found that the coated plate glass in which the low-emissive film includes the above nine layers has a desired color difference ∆E and a desired hue designation.

<Example 2> Patterns in which protective film has thickness of 50 nm or more

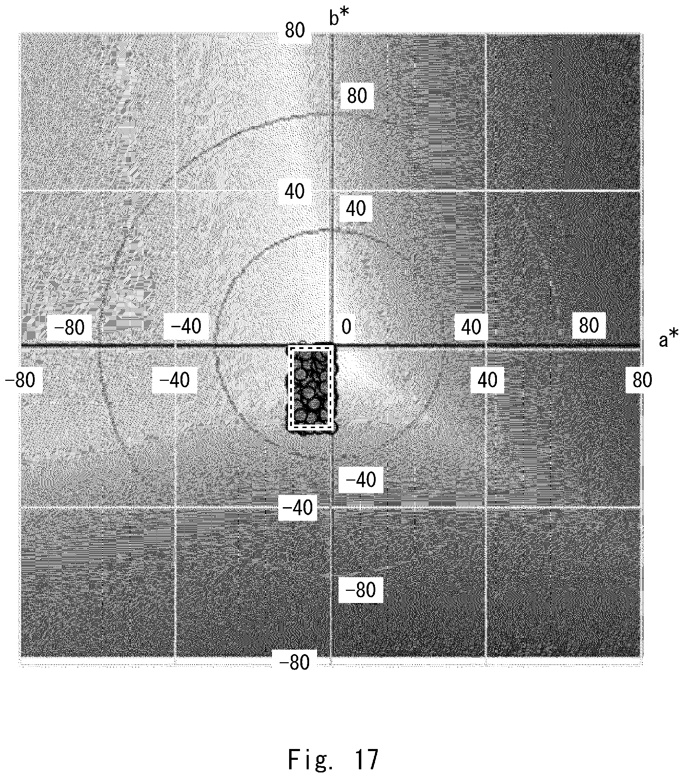

From the 6,000 patterns according to <Example 1>, 1,713 patterns in which the thickness of the protective film was 50 nm or more were extracted. Moreover, from 1,713 patterns, 206 patterns that satisfied the range of the hue designation: the a* value was -10 or more and 0 or less, and the b* value was -20 or more and 0 or less were extracted. As shown in Fig. 17, these 206 patterns were plotted in the two-dimensional coordinate system.

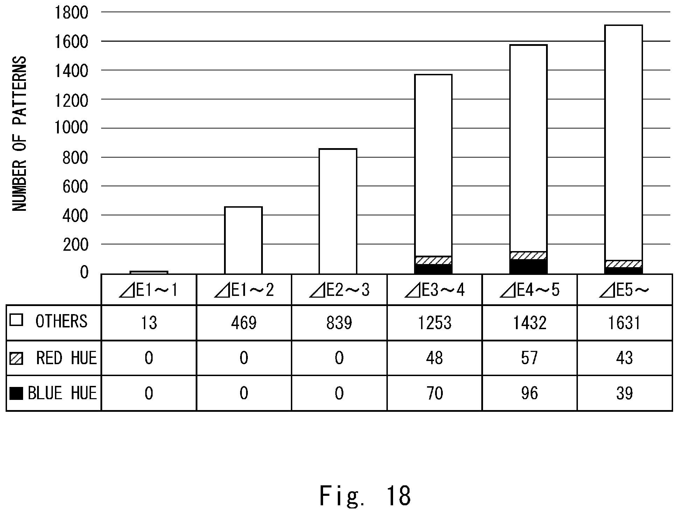

As shown in Fig. 18, 1,713 patterns were classified based on the hue designation and the color difference ∆E. The hue designation of blue hue is shown in the explanation of Fig. 17. The hue designation of red hue was considered to have an a* value of 0 or more and +10 or less and a b* value of 0 or more and +20 or less. From 1,713 patterns, 157 patterns that satisfied the hue designation of red hue were extracted.

<Example 3> Simulation of low-emissive film formed of three layers

The simulation was performed in the same manner as in <Example 1> except for the following points. The combinations of the minimum limit size of the protective film, and thicknesses of the Layer L (2) to the Layer L (4) in the low-emissive film and the Layer L (1) formed of the plate glass were randomly changed using random numbers within the following ranges.

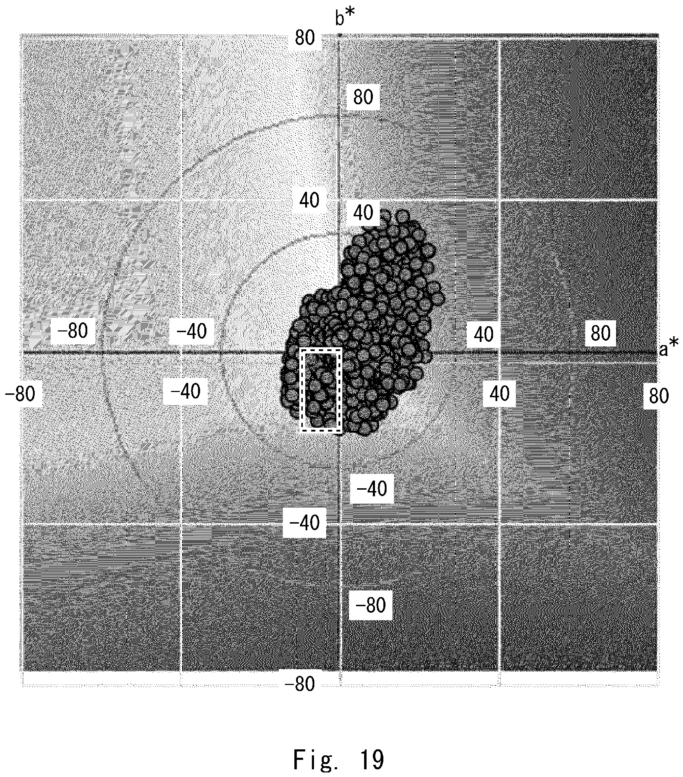

Two thousand patterns of this combination were obtained as shown in Fig. 19. Based on the combination of the thicknesses of each pattern, the set of the L* value, the a* value, and the b* value in the L*a*b* color system was further determined.

Protective film _____ thickness of from 25 to 75 mm
Layer L (4)__second dielectric layer__thickness of from 10 to 50 nm
Layer L (3)__metallic layer_____thickness of from 5 to 50 nm
Layer L (2)__first dielectric layer__thickness of from 10 to 50 nm
Layer L (1)__plate glass____thickness of 3 mm

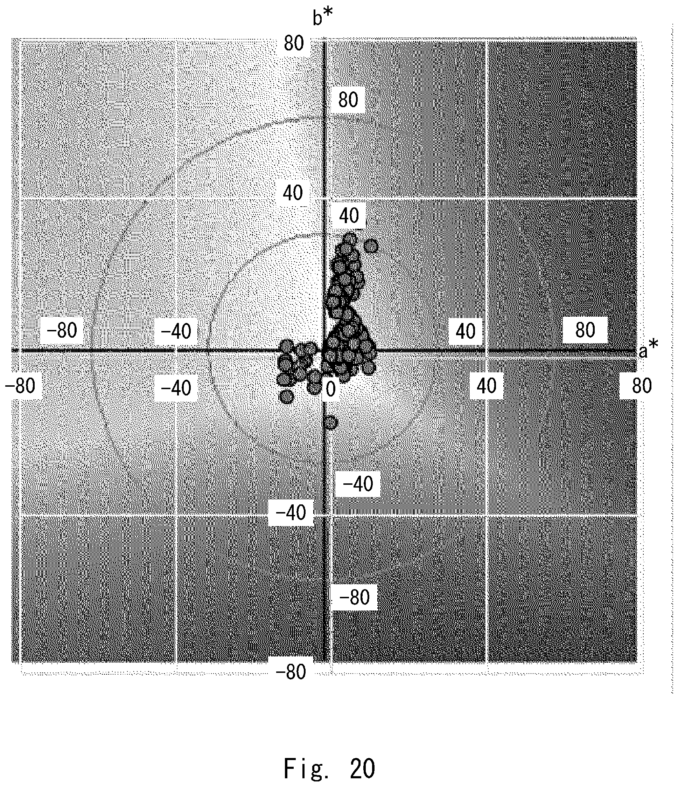

As shown in Fig. 20, 390 patterns in which the color difference ∆E<1 was satisfied were extracted from 2,000 patterns. These patterns were plotted in the two-dimensional coordinate system.

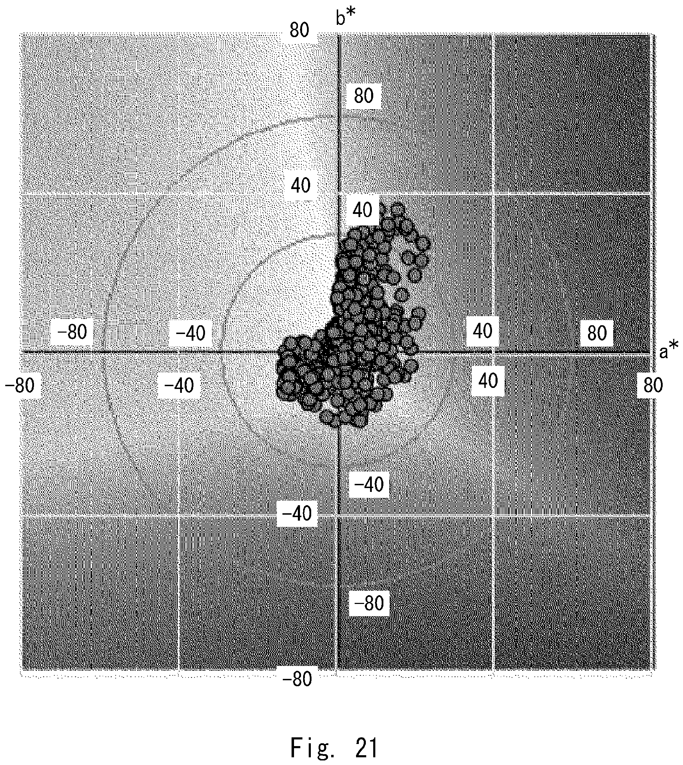

As shown in Fig. 21, 1,136 patterns in which the color difference ∆E<2 was satisfied were extracted from 2,000 patterns. These patterns were plotted in the two-dimensional coordinate system.

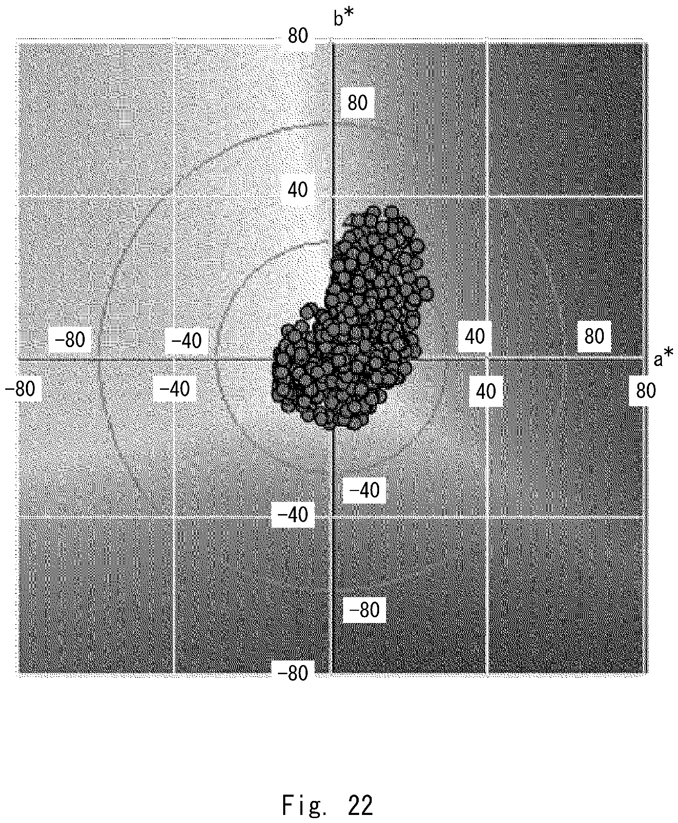

As shown in Fig. 22, 1,753 patterns in which the color difference ∆E<3 was satisfied were extracted from 2,000 patterns. These patterns were plotted in the two-dimensional coordinate system.

<Example 4> Simulation of low-emissive film formed of five layers

The simulation was performed in the same manner as in <Example 1> except for the following points. The combinations of the minimum limit size of the protective film, and thicknesses of the Layer L (2) to the Layer L (6) in the low-emissive film and the Layer L (1) formed of the plate glass were randomly changed using random numbers within the following ranges.

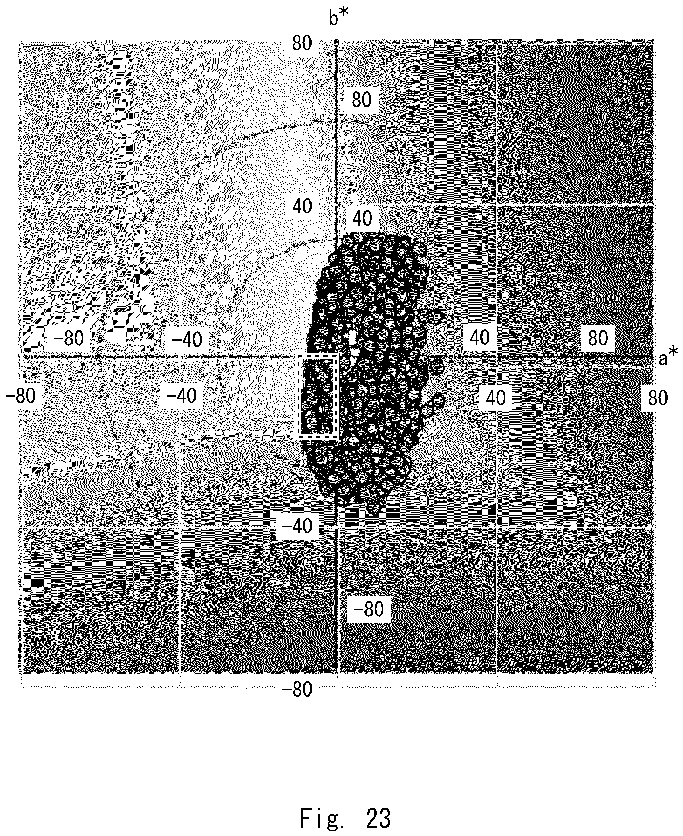

As shown in Fig. 23, 3,000 patterns of this combination were obtained. Based on the combination of the thickness of each pattern, the set of the L* value, the a* value, and the b* value in the L*a*b* color system was further determined.

Protective film _____ thickness of from 25 to 75 mm
Layer L (6)__second dielectric layer__thickness of from 10 to 100 nm
Layer L (5)__buffer layer__thickness of from 0.5 to 9.5 nm
Layer L (4)__metallic layer_____thickness of from 8 to 12 nm
Layer L (3)__buffer layer__thickness of from 0.5 to 9.5 nm
Layer L (2)__first dielectric layer__thickness of from 10 to 50 nm
Layer L (1)__plate glass____thickness of 3 mm

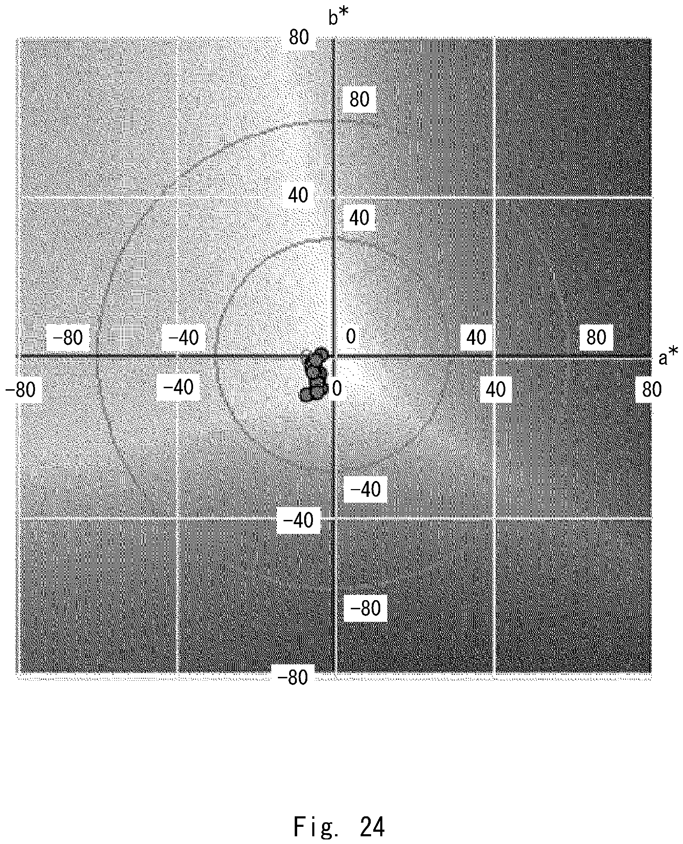

As shown in Fig. 24, 13 patterns in which the color difference ∆E<1 was satisfied were extracted from 3,000 patterns. These patterns were plotted in the two-dimensional coordinate system.

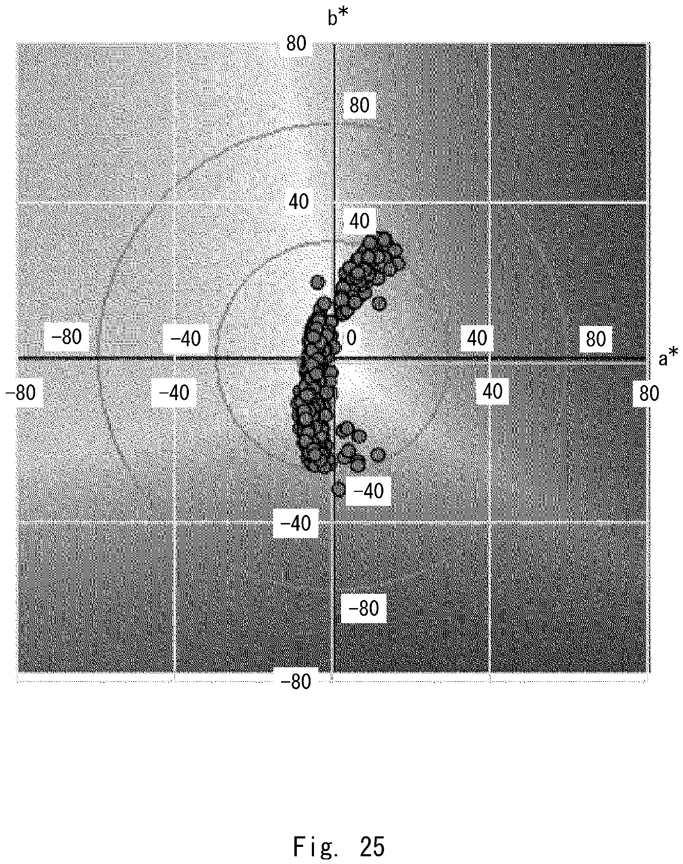

As shown in Fig. 25, 519 patterns in which the color difference ΔE<2 was satisfied were extracted from 3,000 patterns. These patterns were plotted in the two-dimensional coordinate system.

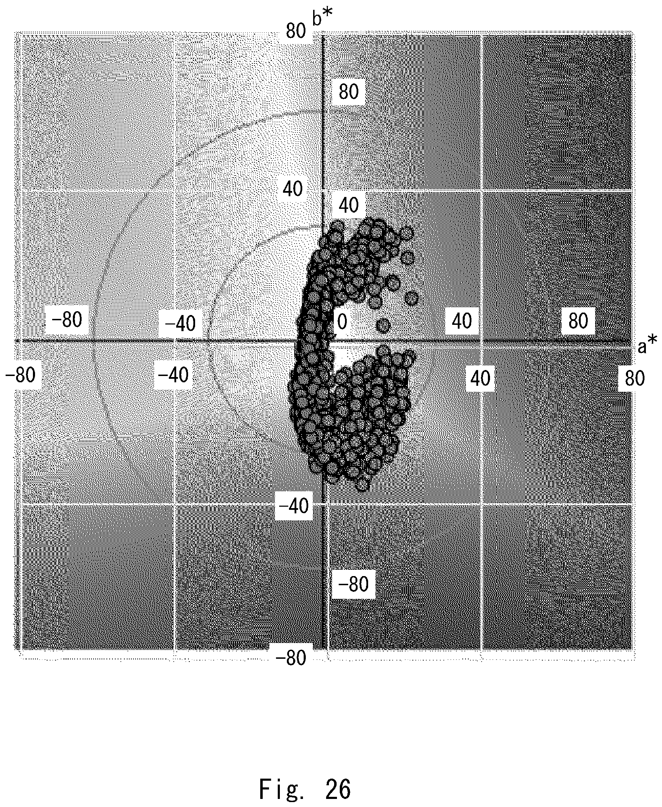

As shown in Fig. 26, 1,556 patterns in which the color difference ΔE<3 was satisfied were extracted from 3,000 patterns. These patterns were plotted in the two-dimensional coordinate system.

<Example 5> Simulation of low-emissive film formed of seven layers

The simulation was performed in the same manner as in <Example 1> except for the following points. The combinations of the minimum limit size of the protective film, and thicknesses of the Layer L (2) to the Layer L (6) in the low-emissive film and the Layer L (1) formed of the plate glass were randomly changed using random numbers within the following ranges.

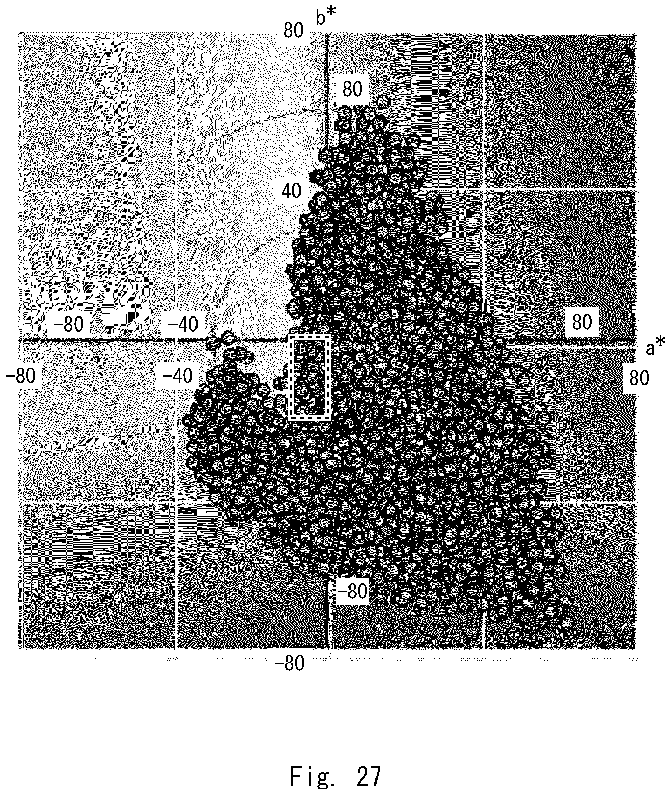

As shown in Fig. 27, 3,000 patterns of this combination were obtained. Based on the combination of the thickness of each thickness, the set of the L* value, the a* value, and the b* value in the L*a*b* color system was further determined.

```
Protective film _____thickness of from 25 to 75 mm
Layer L (8)__third dielectric layer__thickness of from 10 to 50 nm
Layer L (7)__buffer layer__thickness of from 0.5 to 9.5 nm
Layer L (6)__second dielectric layer__thickness of from 50 to 100 nm
Layer L (5)__buffer layer__thickness of from 0.5 to 9.5 nm
Layer L (4)__metallic layer_____thickness of from 8 to 12 nm
Layer L (3)__buffer layer__thickness of from 0.5 to 9.5 nm
Layer L (2)__first dielectric layer__thickness of from 10 to 50 nm
Layer L (1)__plate glass_____thickness of 3 mm
```

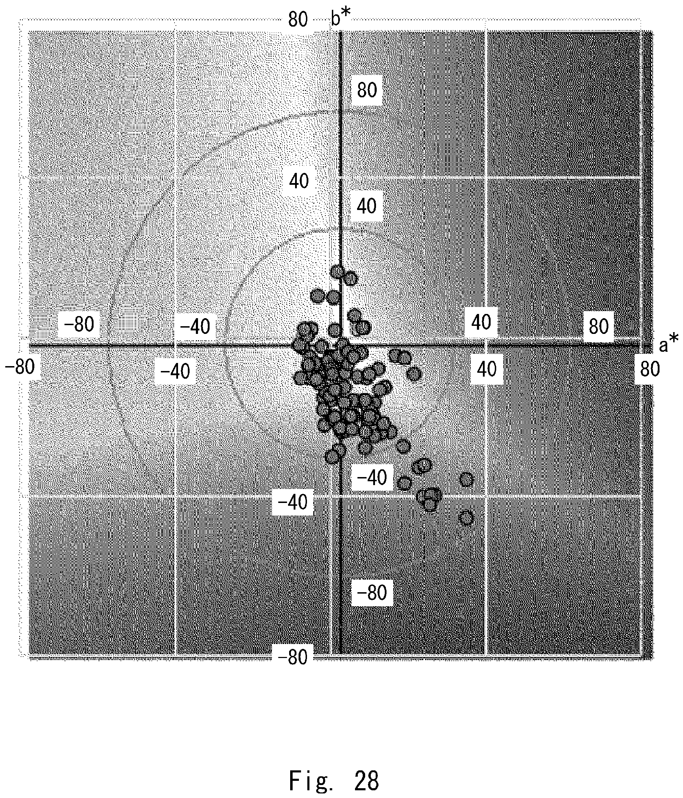

As shown in Fig. 28, 95 patterns in which the color difference ΔE<1 was satisfied were extracted from 3,000 patterns. These patterns were plotted in the two-dimensional coordinate system.

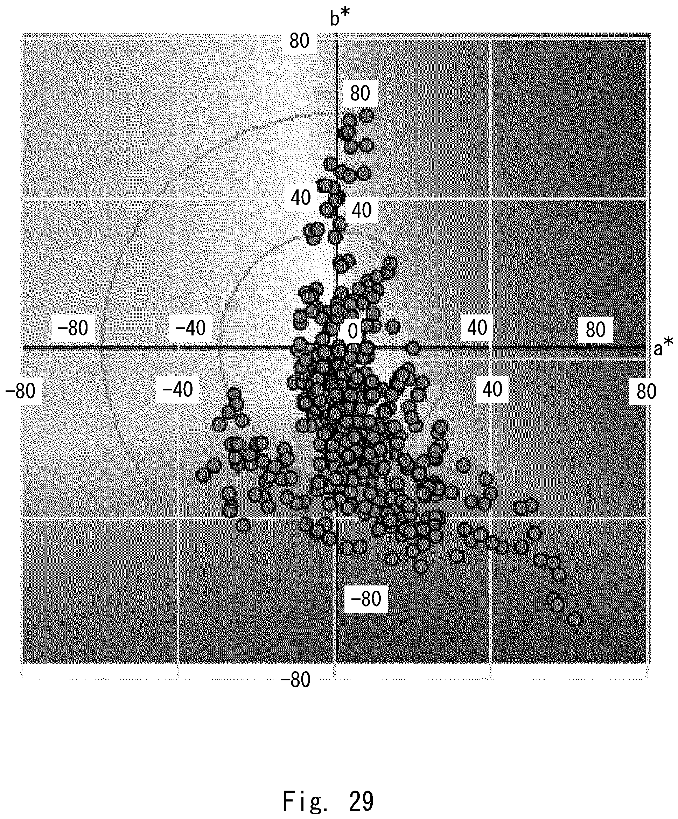

As shown in Fig. 29, 408 patterns in which the color difference ΔE<2 was satisfied were extracted from 3,000 patterns. These patterns were plotted in the two-dimensional coordinate system.

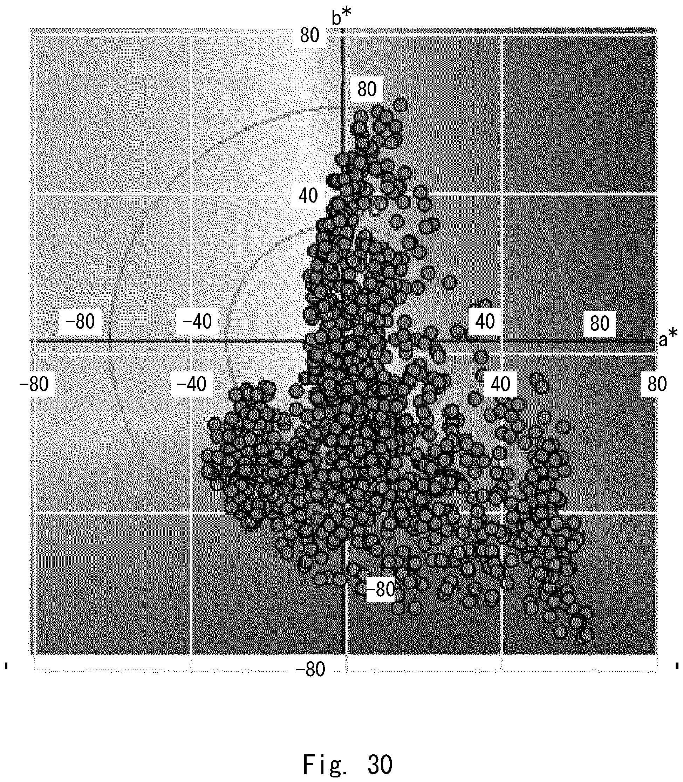

As shown in Fig. 30, 1,088 patterns in which the color difference ΔE<3 was satisfied were extracted from 3,000 patterns. These patterns were plotted in the two-dimensional coordinate system.

<Example 6> Simulation of low-emissive film formed of nine layers

The simulation was performed in the same manner as in <Example 1> except for the following points. The combinations of the minimum limit size of the protective film, and thicknesses of the Layer L (2) to the Layer L (6) in the low-emissive film and the Layer L (1) formed of the plate glass were randomly changed using random numbers within the following ranges.

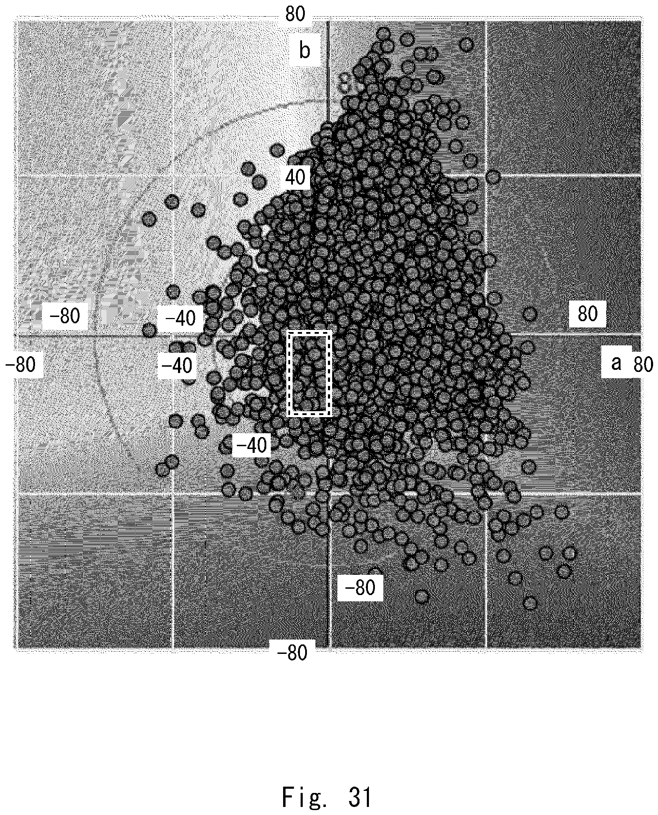

As shown in Fig. 31, 10,000 patterns of this combination were obtained. Based on the combination of the thickness of each thickness, the set of the L* value, the a* value, and the b* value in the L*a*b* color system was further determined.

```
Protective film _____thickness of from 25 to 200 mm
Layer L (10)_third dielectric layer__thickness of from 10 to 50 nm
Layer L (9)__buffer layer__thickness of from 0.5 to 20 nm
Layer L (8)__metallic layer_____thickness of from 5 to 30 nm
Layer L (7)__buffer layer__thickness of from 0.5 to 20 nm
Layer L (6)__second dielectric layer__thickness of from 10 to 100 nm
Layer L (5)__buffer layer__thickness of from 0.5 to 20 nm
Layer L (4)__metallic layer_____thickness of from 5 to 20 nm
Layer L (3)__buffer layer__thickness of from 0.5 to 20 nm
Layer L (2)__first dielectric layer__thickness of from 10 to 50 nm
Layer L (1)__plate glass_____thickness of 3 mm
```

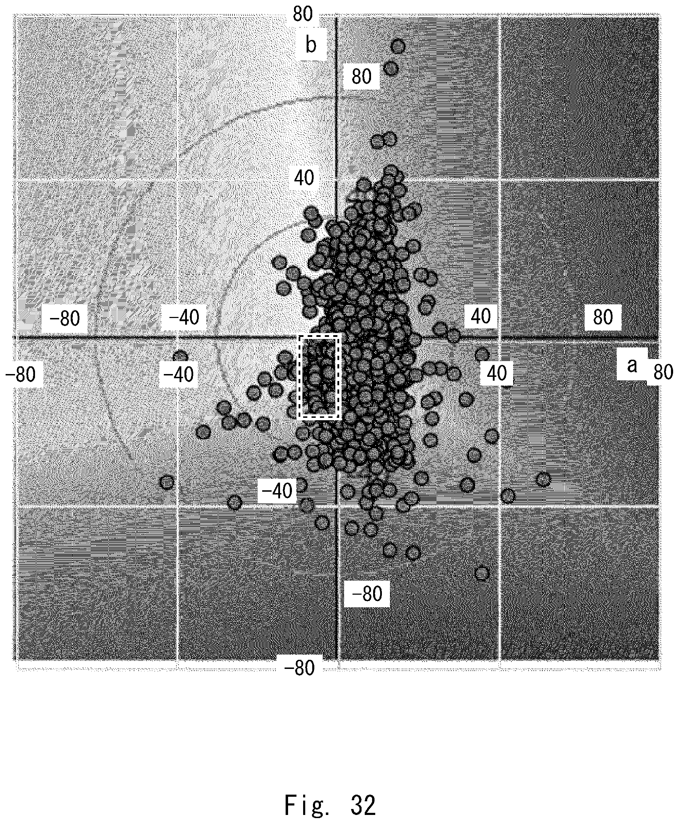

As shown in Fig. 32, 1,588 patterns in which the color difference ΔE<3.5 was satisfied were extracted from 10,000 patterns. These patterns were plotted in the two-dimensional coordinate system.

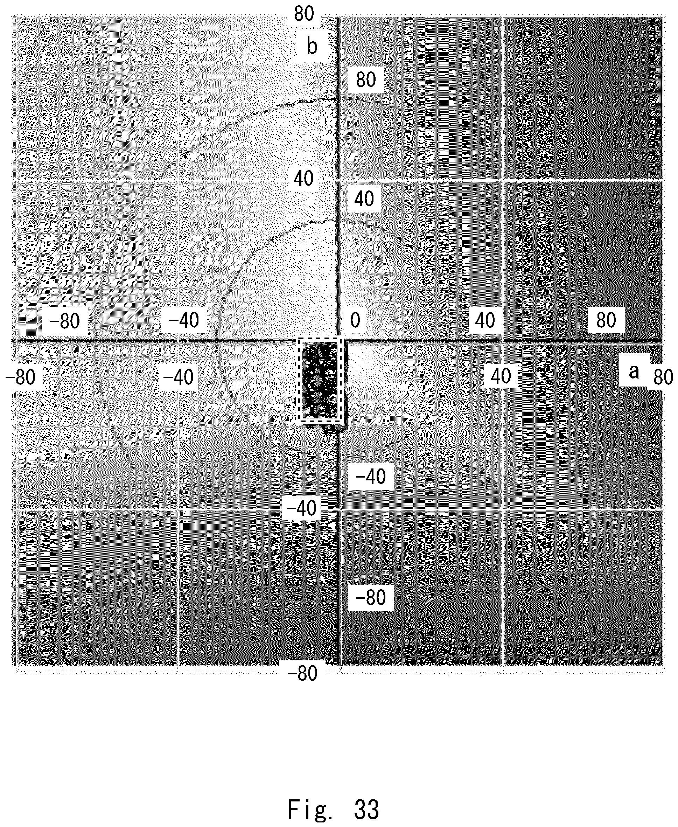

Fig. 33 shows plots obtained by extracting, from 1,588 patterns, 171 patterns that satisfied the range of the hue designation: the a* value was -10 or more and 0 or less, and the b* value was -20 or more and 0 or less.

<Example 7> Actually produced coated plate glass including low-emissive film formed of nine layers and protective film

On Layer L (1) formed of a plate glass (float glass), low-emissive films: Layer L (2) to Layer L (10) and a protective film having configuration described in Table 4 below were formed in the following manner, to obtain a coated plate glass.
First, on the plate glass, an inline-type sputtering apparatus was used to form a film of the low-emissive film so that SiN layer, NiCr layer, Ag layer, NiCr layer, SiN layer, NiCr layer, Ag layer, NiCr layer, and SiN layer were placed in this order, to form the plate glass including the low-emissive film. Note that, the thickness of each of the layers L (2) to L (10) in the following Table 4 was calculated by proportional conversion with the input power based on the thickness obtained when the film was formed with the input power set in advance.
Specifically, for the SiN layer, a target including silicon as a main component, which was a sputtering target, was placed, and AC sputtering was performed under an atmosphere including argon and nitrogen, to form a film.
For the NiCr layer, a target including nickel-chromium alloy (ratio % by weight was Ni : Cr = 80 : 20) as a main component, which was a sputtering target, was placed, and DC sputtering was performed under an argon atmosphere, to form a film.
For the Ag layer, a target including silver as a main component, which was a sputtering target, was placed, and DC sputtering was performed under an argon atmosphere, to form a film.
The above plate glass including the low-emissive film (size: 200 mm × 300 mm) was washed and air-dried.
After air-drying, a sol-gel silica liquid containing zirconia beads for forming a protective film (solid content concentration of 2.4 wt%) was coated on the surface of the low-emissive film of the glass including the low-emissive film by a roll coating method, to prepare a plate glass including the coating film on which the coating film had been formed.
Into an air-heating furnace in which a furnace temperature had been adjusted to 130°C, the plate glass including the coating film was charged and was heated for 10 minutes to cure the coating film, followed by cooling at room temperature, to thereby obtain the coated plate glass of Example 7. Note that, the thickness of each layer is as described in Table 4.

<Example 8> Actually produced coated plate glass including low-emissive film formed of nine layers and protective film

First, on the plate glass, an inline-type reactive DC magnetron sputtering apparatus was used to form a film of the low-emissive film so that SiN layer, NiCr layer, Ag layer, NiCr layer, SiN layer, NiCr layer, Ag layer, NiCr layer, and SiN layer were placed in this order, to form the plate glass including the low-emissive film. Note that, the thickness of each of the layers L (2) to L (10) in the following Table 4 was calculated by proportional conversion with the input power based on the thickness obtained when the film was formed with the input power set in advance.
Specifically, for the SiN layer, a target including silicon as a main component, which was a sputtering target (target size: 70 mm × 200 mm), was placed, and sputtering was performed under an atmosphere including argon and nitrogen (Ar : N2 = 40 sccm: 60 sccm, pressure: 0.4 Pa), to form a film. The sputtering power was set to 500 W.
For the NiCr layer, a target including nickel-chromium alloy (ratio % by weight was Ni : Cr = 80 : 20) as a main component, which was a sputtering target (target size: 70 mm × 200 mm), was placed, and sputtering was performed under an argon atmosphere (100 sccm, pressure: 0.4 Pa), to form a film. The sputtering power was set to 100 W.
For the Ag layer, a target including silver as a main component, which was a sputtering target (target size: 70 mm × 200 mm), was placed, and sputtering was performed under an argon atmosphere (50 sccm), to form a film. The sputtering power was set to 100 W.
The above plate glass including the low-emissive film (size: 200 mm × 300 mm) was washed and air-dried.
After air-drying, a sol-gel silica liquid containing zirconia beads for forming a protective film (solid content concentration of 2.4 wt%) was coated on the surface of the low-emissive film of the glass including the low-emissive film by a roll coating method, to prepare a plate glass including the coating film on which the coating film had been formed.
Into an air-heating furnace in which a furnace temperature had been adjusted to 130°C, the plate glass including the coating film was charged and was heated for 10 minutes to cure the coating film, followed by cooling at room temperature, to thereby obtain the coated plate glass of Example 8. Note that, the thickness of each layer is as described in Table 4.

[Evaluation]

<Measurement of in-plane color difference ΔE>

Each of the coated plated glasses of Examples 7 and 8 was measured for chromaticity using a spectra colorimeter CM-600d available from KONICA MINOLTA, INC. Measurement was performed at 30 points in the same straight line in a direction parallel to the transport direction of the roll coating. The interval between the measurement positions at that time was 5 mm. Then, the color differences between all measurement points and adjacent measurement points were calculated, and the maximum color difference was defined as ΔE.

In addition, the colorimeter was used to calculate average values of the a* value and the b* value (30 points) on the coated surface. The results are shown in Table 5.

<Measurement of reflectance>

Each of the coated plated glasses of Examples 7 and 8 was measured for reflection spectrum using a spectra colorimeter CM-600d available from KONICA MINOLTA, INC. For the measurement of reflectance, the reflectances of a wavelength of from 380 nm to 780 nm from a side of the low-emissive film were measured to determine an average reflectance. The results are shown in Table 5.

<Observation of stripe-like patterns>

When the reflected images of the surfaces of the respective coated glass plates of Examples 7 and 8 were observed using a surface light source, no stripe-like pattern as shown in FIG. 10 was observed in either Examples 7 or 8.

[Table 4]

Table 4

| | | Glass | Layers in low-emissive film | | | | | | | | | | Protective film |
|---|---|---|---|---|---|---|---|---|---|---|---|---|---|
| | | L (1) | L (2) | L (3) | L (4) | L (5) | L (6) | L (7) | L (8) | L (9) | L (10) | |
| | Material | Float glass | SiN | NiCr | Ag | NiCr | SiN | NiCr | Ag | NiCr | SiN | SiO2+ZrO2 particles |
| Example 7 | Thickness | 5.9 mm | 25.0 nm | 2.0 nm | 13.0 nm | 1.8 nm | 90.0 nm | 1.8 nm | 13.0 nm | 1.6 nm | 15.0 nm | 50.00 nm to 52.21 nm |
| Example 8 | Thickness | 2.7 mm | 20.0 nm | 2.0 nm | 160 nm | 2.0 nm | 60.0 nm | 2.0 nm | 8.0 nm | 5.0 nm | 40.0 nm | 50.00 nm to 51.38 nm |

Table 5

| | In-plane color difference ΔE | Presence or absence of stripe unevenness | Chromaticity | | | Average reflectance (380 to 780nm) |
|---|---|---|---|---|---|---|
| | | | L* | a* | b* | |
| Example 7 | 2.9 | Absence | 57.7 | -12.1 | -12.0 | 11.0% |
| Example 8 | 0.9 | Absence | 43.9 | -5.1 | -1.2 | 13.3% |

Tables 4 and 5 showed that, the coated plate glasses of Examples 7 and 8, in which the low-reflective film and the protective film were included, the variation of the thickness of the protective film fell within a specific range, and the in-plane color difference ΔE was 3.5 or less, had reduced stripe-like patterns.

This application claims priority to Japanese Patent Application No. 2022-049823, filed on March 25, 2022, and the entire disclosure thereof is incorporated herein.

**Reference Signs List**

Cg: coated plate glass, Cs: coated surface, D: thickness of protective film, thicknesses of $D_1$ to $D_N$ layers, De: dielectric layer, Dv: deviation, Gs: plate glass, L (1)-L (N): first layer to $N^{th}$ layer, Le: low-emissive film, Lg: laminate, Ls: minimum limit size, Mn: point, Mt: metallic layer, Mx: point, Ob: observer, Pr: protective film, Tr: tolerance, Wt: white light, θ1: incidence angle of light, θ2: angle of refraction

**Claims**

1. A coated plate glass comprising:

   a plate glass having a coated surface;
   a low-emissive film that is disposed on the coated surface and includes a metallic layer and a dielectric layer; and
   a protective film that is disposed on the low-emissive film and based on silica,
   wherein a thickness at each point of the protective film has variation, a deviation with respect to a minimum limit size of the thickness at the each point in the thickness at the each point falls within a range of a tolerance of the thickness at the each point, and the tolerance is set to a value of 10% or less of the minimum limit size,
   when the coated plate glass is observed from above the protective film, a color difference ΔE between two points that are a point at which a thickness of the protective film is a maximum limit size and a point at which a thickness of the protective film is the minimum limit size, is 3.5 or less, and
   the color difference ΔE is determined by an equation described below:

   $$[\text{Expression 1}]$$

   $$\Delta E = \sqrt{(\Delta L^*)^2 + (\Delta a^*)^2 + (\Delta b^*)^2}$$

   wherein ΔL* is a difference between L* values at respective points in an L*a*b* color system,
   Δa* is a difference between a* values at respective points in the L*a*b* color system, and
   Δb* is a difference between b* values at respective points in the L*a*b* color system.

2. The coated plate glass according to claim 1,

   wherein the low-emissive film includes a plurality of dielectric layers, and
   the plurality of dielectric layers includes: a first dielectric layer positioned between the coated surface of the plate glass and the metallic layer; and a second dielectric layer positioned between the metallic layer and the protective film.

3. The coated plate glass according to claim 2,

   wherein the low-emissive film further includes a plurality of buffer layers,
   the plurality of buffer layers includes: a first buffer layer positioned between the first dielectric layer and the metallic layer; and a second buffer layer positioned between the metallic layer and the second dielectric layer, the first buffer layer includes a composition having a refractive index higher than a refractive index of the first dielectric layer and a refractive index of the metallic layer, and is thinner than the first dielectric layer, and a refractive index of the second buffer layer includes a composition having a refractive index higher than the refractive index of the metallic layer and a refractive index of the second dielectric layer, and is thinner than the second dielectric layer.

4. The coated plate glass according to claim 2,

wherein the low-emissive film includes, in addition to the metallic layer that is referred to as a first metallic later later, a second metallic layer positioned between the second dielectric layer and the protective film, the plurality of dielectric layers further includes a third dielectric layer positioned between the second metallic layer and the protective film, the dielectric layer and the metallic layer adjacent to each other are connected by the buffer layer, and each buffer layer includes a composition having a refractive index higher than refractive indexes of the dielectric layer and the metallic layer connected by the buffer layer, and is thinner than each dielectric layer.

5. The coated glass according to claim 1, wherein a minimum value of the thickness of the protective film actually measured on the coated surface is 25 nm or more and 200 nm or less.

6. The coated glass according to claim 5, wherein the minimum value of the thickness of the protective film actually measured on the coated surface is 75 nm or less.

7. The coated glass according to claim 5, wherein the minimum value of the thickness of the protective film on the coated surface is 50 nm or more.

8. The coated plate glass according to claim 5, wherein the low-emissive film includes, from the protective film toward the plate glass, nine layers described below:

· third dielectric layer: 10 to 70 nm
· buffer layer: 1 to 20 nm
· second metallic layer: 1 to 30 nm
· buffer layer: 1 to 20 nm
· second dielectric layer: 10 to 120 nm
· buffer layer: 1 to 20 nm
· first metallic layer: 1 to 30 nm
· buffer layer: 1 to 20 nm
· first dielectric layer: 10 to 70 nm.

9. The coated plate glass according to claim 5, wherein the low-emissive film includes, from the protective film toward the plate glass, nine layers described below:

· third dielectric layer: 10 to 45 nm
· buffer layer: 1 to 9 nm
· second metallic layer: 5 to 20 nm
· buffer layer: 1 to 9 nm
· second dielectric layer: 51 to 99 nm
· buffer layer: 1 to 9 nm
· first metallic layer: 8 to 20 nm
· buffer layer: 1 to 9 nm
· first dielectric layer: 16 to 48 nm.

10. The coated plate glass according to claim 5, wherein the low-emissive film includes, from the protective film toward the plate glass, nine layers described below:

· third dielectric layer: 10 to 45 nm

· buffer layer: 1 to 9 nm
· second metallic layer: 12 to 20 nm
· buffer layer: 1 to 9 nm
· second dielectric layer: 51 to 99 nm
· buffer layer: 5 to 9 nm
· first metallic layer: 8 to 12 nm
· buffer layer: 1 to 9 nm
· first dielectric layer: 16 to 48 nm.

11. The coated plate glass according to claim 5,
wherein the low-emissive film includes, from the protective film toward the plate glass, nine layers described below:

· third dielectric layer: 10 to 45 nm
· buffer layer: 1 to 9 nm
· second metallic layer: 5 to 18 nm
· buffer layer: 1 to 9 nm
· second dielectric layer: 51 to 99 nm
· buffer layer: 1 to 9 nm
· first metallic layer: 12 to 20 nm
· buffer layer: 1 to 9 nm
· first dielectric layer: 16 to 48 nm.

12. The coated plate glass according to claim 5,
wherein when the plate glass is observed from a side of the protective film, the coated surface has an a* value of -15 or more and 0 or less and a b* value of - 20 or more and 0 or less.

13. The coated plate glass according to claim 5,
wherein when the plate glass is observed from a side of the protective film, the coated surface has an a* value of -10 or more and 0 or less and a b* value of - 20 or more and 0 or less.

14. The coated plate glass according to claim 1,
wherein the coated plate glass is a single plate glass.

15. The coated plate glass according to claim 14,
wherein when a reflectance of the plate glass is measured at a wavelength of from 380 nm to 780 nm from a side of the low-emissive film, the reflectance is 15% or less.

16. The coated plate glass according to claim 14,
wherein when a reflectance of the plate glass is measured at a wavelength of from 380 nm to 780 nm from a side of the low-emissive film, the reflectance is 5% or less.

17. A coated plate glass comprising:

a plate glass having a coated surface;
a low-emissive film that is disposed on the coated surface and includes a metallic layer and a dielectric layer; and
a protective film that is disposed on the low-emissive film and based on silica,
wherein when a thickness at each point of the protective film is measured, a difference between a maximum thickness of the protective film and a minimum thickness of the protective film is a value of 10% or less of the minimum thickness, and
when the coated plate glass is observed from above the protective film, a color difference ΔE between two points that are a point of the maximum thickness and a point of the minimum thickness, is 3.5 or less, and
the color difference ΔE is determined by an equation described below:

[Expression 2]

$$\Delta E = \sqrt{(\Delta L^{*})^2 + (\Delta a^{*})^2 + (\Delta b^{*})^2}$$

wherein ΔL* is a difference between L* values at respective points in an L*a*b* color system,

Δa* is a difference between a* values at respective points in the L*a*b* color system, and
Δb* is a difference between b* values at respective points in the L*a*b* color system.

18. A method for preparing the coated plate glass according to any one of claims 1 to 17, the method comprising:

    laminating sol of alkoxysilane on the low-emissive film through roll coating, die coating, or spray coating to gelate the sol on the low-emissive film, wherein the protective film is a silica film; or
    laminating silazane on the low-emissive film through roll coating, die coating, or spray coating to convert the silazane into silica on the low-emissive film, wherein the protective film is a silica film.

19. A method for designing the coated plate glass according to any one of claims 1 to 17 by selecting, from a plurality of patterns obtained by simulations, a combination of a thickness of the protective film, a thickness of each layer in the low-emissive film, and a thickness of the plate glass, the method comprising:

    determining a spectral solid angle reflectance R (λ) on the coated surface in each pattern of a combination of the minimum limit size of the thickness of the protective film, the thickness of each layer in the low-emissive film, and the thickness of the plate glass, and replacing the thickness of the protective film with the maximum limit size in each pattern, to determine the spectral solid angle reflectance R (λ),
    obtaining a set of an L* value, an a* value, and a b* value in an L*a*b* color system in each pattern, based on the spectral solid angle reflectance R (λ) according to the minimum limit size and the maximum limit size of the thickness of the protective film; and
    determining a color difference ΔE represented by an equation described below in each pattern, based on the equation below:

$$[\text{Expression 3}]$$

$$\Delta E = \sqrt{(\Delta L^*)^2 + (\Delta a^*)^2 + (\Delta b^*)^2}$$

ΔL* is a difference between an L* value corresponding to the minimum limit size of the thickness of the protective film and an L* value corresponding to the maximum limit size of the thickness of the protective film,
Δa* is a difference between an a* value corresponding to the minimum limit size of the thickness of the protective film and an a* value corresponding to the maximum limit size of the thickness of the protective film, and
Δb* is a difference between a b* value corresponding to the minimum limit size of the thickness of the protective film and a b* value corresponding to the maximum limit size of the thickness of the protective film.

Fig. 1

Fig. 2

Fig. 3

λ (nm)

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

| | | △E1〜1 | △E1〜2 | △E2〜3 | △E3〜4 | △E4〜5 | △E5〜 |
|---|---|---|---|---|---|---|---|
| □ | OTHERS | 13 | 469 | 839 | 1253 | 1432 | 1631 |
| ▨ | RED HUE | 0 | 0 | 0 | 48 | 57 | 43 |
| ■ | BLUE HUE | 0 | 0 | 0 | 70 | 96 | 39 |

Fig. 18

Fig. 19

Fig. 20

Fig. 21

Fig. 22

Fig. 23

Fig. 24

Fig. 25

Fig. 26

Fig. 27

Fig. 28

Fig. 29

Fig. 30

Fig. 31

Fig. 32

Fig. 33

## INTERNATIONAL SEARCH REPORT

| International application No. |
| --- |
| **PCT/JP2023/010478** |

**A. CLASSIFICATION OF SUBJECT MATTER**

*C03C 17/36*(2006.01)i; *B32B 9/00*(2006.01)i; *B32B 15/04*(2006.01)i
FI:   C03C17/36; B32B9/00 A; B32B15/04 B

According to International Patent Classification (IPC) or to both national classification and IPC

**B. FIELDS SEARCHED**

Minimum documentation searched (classification system followed by classification symbols)

C03C15/00-23/00; B32B9/00; B32B15/04

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | WO 2019/189109 A1 (NIPPON SHEET GLASS CO., LTD.) 03 October 2019 (2019-10-03) entire text | 1-19 |
| A | JP 2015-532256 A (GUARDIAN INDUSTRIES CORP.) 09 November 2015 (2015-11-09) entire text | 1-19 |
| A | JP 08-239245 A (GUARDIAN INDUSTRIES CORP.) 17 September 1996 (1996-09-17) entire text | 1-19 |

☐ Further documents are listed in the continuation of Box C.     ☑ See patent family annex.

| | |
| --- | --- |
| *     Special categories of cited documents:<br>"A"   document defining the general state of the art which is not considered to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
| --- | --- |
| **19 May 2023** | **30 May 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/010478**

| Patent document cited in search report | | | Publication date (day/month/year) | Patent family member(s) | | | Publication date (day/month/year) |
|---|---|---|---|---|---|---|---|
| WO | 2019/189109 | A1 | 03 October 2019 | (Family: none) | | | |
| JP | 2015-532256 | A | 09 November 2015 | US | 2014/0098415 | A1 | |
| | | | | whole document | | | |
| | | | | US | 2015/0132555 | A1 | |
| | | | | US | 2016/0340235 | A1 | |
| | | | | WO | 2014/055267 | A2 | |
| | | | | EP | 2903946 | A2 | |
| | | | | TW | 201418755 | A | |
| | | | | KR | 10-2015-0065740 | A | |
| | | | | CN | 104837785 | A | |
| | | | | MX | 2015003868 | A | |
| | | | | RU | 2015116912 | A | |
| | | | | BR | 102012033448 | A | |
| | | | | IN | 2720DEN2015 | A | |
| | | | | BR | 112015007463 | A | |
| | | | | PL | 2903946 | T | |
| | | | | ES | 2705850 | T | |
| | | | | TR | 201900648 | T | |
| JP | 08-239245 | A | 17 September 1996 | US | 5557462 | A | |
| | | | | whole document | | | |
| | | | | EP | 722913 | A1 | |
| | | | | DE | 69600460 | C | |
| | | | | NO | 960193 | D | |
| | | | | PL | 312346 | A | |
| | | | | ES | 2120789 | T | |
| | | | | HU | 9600088 | A | |
| | | | | AT | 168975 | T | |
| | | | | CA | 2167444 | A | |
| | | | | CZ | 13296 | A | |
| | | | | SI | 722913 | T | |
| | | | | SK | 6296 | A | |
| | | | | DK | 722913 | T | |
| | | | | CN | 1134921 | A | |
| | | | | KR | 10-1996-0029262 | A | |
| | | | | AT | 168975 | E | |
| | | | | NO | 960193 | D0 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004522673 W
- JP 2007534603 W
- WO 2019189109 A
- JP 2018512369 W
- WO 2022014650 A
- JP 2022049823 A